(19) Europäisches Patentamt
European Patent Office
Office européen des brevets

(11) EP 0 900 239 B1

(12) EUROPÄISCHE PATENTSCHRIFT

(45) Veröffentlichungstag und Bekanntmachung des Hinweises auf die Patenterteilung:
**27.03.2002 Patentblatt 2002/13**

(21) Anmeldenummer: **97923082.8**

(22) Anmeldetag: **15.05.1997**

(51) Int Cl.[7]: **C08F 8/00**, C08F 220/34, G11B 7/24

(86) Internationale Anmeldenummer:
**PCT/EP97/02489**

(87) Internationale Veröffentlichungsnummer:
**WO 97/44365 (27.11.1997 Gazette 1997/51)**

(54) **SCHNELL FOTOADRESSIERBARE SUBSTRATE SOWIE FOTOADRESSIERBARE SEITENGRUPPENPOLYMERE MIT HOHER INDUZIERBARER DOPPELBRECHUNG**

PHOTO-ADDRESSABLE SUBSTRATES AND PHOTO-ADDRESSABLE SIDE-GROUP POLYMERS WITH HIGHLY INDUCIBLE DOUBLE REFRACTION

SUBSTRATS PHOTO-ADRESSABLES ET POLYMERES DE GROUPES SECONDAIRES PHOTO-ADRESSABLES A BIREFRINGENCE INDUCTIBLE ELEVEE

(84) Benannte Vertragsstaaten:
**BE CH DE DK ES FR GB GR IT LI NL SE**

(30) Priorität: **22.05.1996 DE 19620588**
**29.01.1997 DE 19703132**
**19.02.1997 DE 19706379**

(43) Veröffentlichungstag der Anmeldung:
**10.03.1999 Patentblatt 1999/10**

(73) Patentinhaber: **BAYER AG**
**51368 Leverkusen (DE)**

(72) Erfinder:
- **BERNETH, Horst**
  **D-51373 Leverkusen (DE)**
- **CLAUSSEN, Uwe**
  **D-51379 Leverkusen (DE)**
- **KOSTROMINE, Serguei**
  **D-53913 Swisttal (DE)**
- **NEIGL, Ralf**
  **D/51373 Leverkusen (DE)**
- **VEDDER, Hans-Joachim**
  **D-82178 Puchheim (DE)**

(56) Entgegenhaltungen:

| | |
|---|---|
| **EP-A- 0 260 687** | **EP-A- 0 535 490** |
| **EP-A- 0 538 773** | **EP-A- 0 571 271** |
| **EP-A- 0 704 513** | **DE-A- 4 244 197** |
| **US-A- 3 190 876** | **US-A- 5 332 522** |

EP 0 900 239 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die Erfindung betrifft ein Verfahren zum extrem schnellen Beschreiben fotoadressierbarer Substrate, für dieses Verfahren vorbereitete Substrate und die Verwendung solcher Substrate in der Informationstechnik. Die Erfindung betrifft außerdem fotoadressierbare Seitengruppenpolymere, in denen sich durch Bestrahlung eine hohe Doppelbrechung induzieren läßt, so daß sie sich zur Speicherung optisch angebotener Information oder zur Herstellung passiver oder optisch schaltbarer Komponenten eignen.

Fotoadressierbare Polymere sind bekannt (Polymers as Electrooptical and Photooptical Active Media, V. P. Shibaev (Hrsg.), Springer Verlag, New York 1995). Insbesondere eignen sich für diesen Zweck Seitengruppenpolymere, von denen die Gruppe der Copolymeren sich durch eine sehr breite Variationsmöglichkeit der Eigenschaften auszeichnet. Ihre besondere Eigenart ist, daß ihre optischen Eigenschaften wie Absorption, Emission, Reflexion, Doppelbrechung, Streuung lichtinduziert reversibel verändert werden können. Derartige Polymere haben eine spezielle verzweigte Struktur. An einem linearen Rückgrat sitzen - über als Abstandshalter wirkende Molekülteile verbunden - Seitengruppen, die elektromagnetische Strahlung absorbieren können. Beispiele dieser Art sind die Azobenzolgruppen enthaltenden Seitengruppenpolymeren gemäß US-PS 5 173 381. Diese Substanzen kennzeichnet die Fähigkeit, beim Bestrahlen mit polarisiertem Licht eine gerichtete Doppelbrechung auszubilden. Die eingeschriebenen Doppelbrechungsmuster lassen sich im polarisierten Licht sichtbar machen.

Es ist weiterhin bekannt, daß man in Schichten aus diesen Polymeren an einer beliebigen Stelle mit polarisiertem Licht eine örtlich begrenzte Doppelbrechung einschreiben kann, deren Vorzugsachse sich beim Drehen der Polarisationsrichtung mitbewegt (K. Anderle, R. Birenheide, M. Eich, J.H. Wendorff, Makromol. Chem., Rapid Commun. 10, 477 - 483 (1989), J. Stumpe et al., 20. Freiburger Arbeitstagung Flüssigkristalle 1991). Diese Prozesse sind langsam. Zwar kann man in einigen Fällen bereits nach einigen Sekunden Belichtungszeit den Beginn anisotropen Verhaltens feststellen, aber um den Effekt bis zum erreichbaren Maximum zu entwickeln, bedarf es in der Regel Minuten bis Stunden. Dabei ist die aufzuwendende Zeit der Größe des Effekts etwa proportional. Es ist eine Besonderheit der optischen Adressierung, daß sich die optische Achse der eingeschriebenen Doppelbrechung senkrecht zu der des einschreibenden polarisierten Lichts einstellt. Auf dieser Eigenschaft beruht die einfache Möglichkeit, eingeschriebene Informationen dadurch optisch zu löschen, daß man die Polarisationsrichtung des einschreibenden Lichts dreht. Schreiben und Löschen verlaufen in diesem Falle gleich schnell; es sind bis auf die Polarisationsrichtung des verwendeten Lichts identische Prozesse. Im Gegensatz dazu steht der Prozeß des thermischen Löschens durch Erwärmung der Schicht über die Glasübergangstemperatur des Polymeren, bei dem alle Informationen auf einmal gelöscht werden.

Bei der Informationsdarstellung, Speicherung und Verarbeitung werden zwei grundsätzlich verschiedene Wege beschritten, die seriell und analog genannt werden. Bei dem analogen Weg werden alle Informationen gleichzeitig erfaßt und gewandelt. Ein typisches Beispiel hierfür bietet die Fotografie mit dem Silberhalogenid-Film als analog aufzeichnendem Medium. Dieser Fall trifft bei der Belichtung einer Schicht aus fotoadressierbaren Polymeren durch eine Mustervorlage mit polarisiertem Licht zu. Da alle Bildpunkte gleichzeitig entwickelt werden, ist bei diesen Prozessen die Einschreib-(Entwicklungs)zeit selten kritisch. Beim seriellen Verfahren dagegen werden die Informationen nacheinander aufgerufen. Bei Objekten mit sehr hoher Informationsdichte, beispielsweise Bildern, müssen unter Umständen sehr große Mengen dieser Bildpunkte nacheinander geschrieben werden, wobei die Entwicklungszeit sich als Summe der Entwicklungszeiten der einzelnen Bildpunkte ergibt. Deswegen kommt es hier ganz besonders auf eine hohe Einschreibgeschwindigkeit unter Erhalt einer ausreichenden Stabilität sowohl des Ausgangszustands der nicht beschriebenen Regionen als auch des Endzustandes der beschriebenen Regionen an. Bei beiden Verfahren ist die genaue Wiedergabe von Abstufungen der Helligkeitsunterschiede (Graustufen) der Vorlage außerordentlich wichtig. Es ist bisher nicht gelungen, das Problem der hohen Einschreibgeschwindigkeiten auf optischem Wege technisch zufriedenstellend zu lösen, weil neben der Informationsübertragungsrate weitere Randbedingungen wesentlich sind. Von ihnen sind vor allem die Stabilität, die Löschbarkeit und die Graustufenfähigkeit zu nennen. Dies hat prinzipielle Ursachen.

Als generelle Regel gilt, daß nur Systeme, bei denen keine Masse, sondern Felder oder Vektoren verändert werden, auf Steuerungsbefehle extrem schnell reagieren können. Wenn Masse bewegt wird, also bei Umlagerungsprozessen oder chemischen Reaktionen, ist die Reaktion um Größenordnungen langsamer und wird von der Viskosität des Mediums mitbestimmt. So liegt die Schaltzeit der niederviskosen nematischen Drehzellen maximal im Bereich von msec, während ein Seitengruppencopolymer Minuten, häufig viele Stunden, benötigt, um die maximal erzielbare Doppelbrechung zu erreichen.

Verzichtet man auf die Reversibilität der eingeschriebenen Veränderungen, dann kann man die Energiedichte beliebig wählen und im Grenzfall das Substrat örtlich zerstören. Solche Materialien werden beispielsweise von G. Kämpf in Kirk-Othmer, Encyclo-paedia of Chemical Technology, 4th ed., 14, 277-338 (1995) beschrieben. Dieses in der Literatur in vielen Variationen beschriebene Verfahren hat jedoch einige Nachteile. Der wichtigste ist, daß der Prozeß einen erheblichen Eingriff in das Gefüge des Substrats bedeutet und das gebildete Loch grundsätzlich instabil ist. Ferner hat man immer das Problem des verdampften Materials, das sich irgendwo in der Apparatur oder auf dem

Speichermedium ablagert, und schließlich benötigt man sehr hohe Energiedichten der Laser, in der Regel >$10^7$ mJ/$m^2$.

Da der Erhalt des Substrats zugleich die Bedingung für seine Wiederbeschreibbarkeit ist, kann man die Lichtintensität nicht beliebig steigern; vielmehr muß man unterhalb der Zersetzungsbedingungen bleiben. Es gibt also eine durch die Stabilität des Materials definierte obere Grenze der Energiedichte. Die kleinste Energiemenge, die nötig ist, um eine nachweisbare und stabile Veränderung in der Schicht hervorzurufen, ist von Coles (an einem Polysiloxan) zu 4x$10^6$ mJ/$m^2$ (C.B. McArdle in Side Chain Liquid Crystal Polymers, Hrsgb. C.B. McArdle, Verlag Blackie, Glasgow 1989, S. 374) bestimmt worden. Unter der Annahme, daß die Mindestenergie für polymere Substrate in derselben Größenordnung liegt, folgt, wenn man das Substrat schonend behandeln möchte, daß die Seitengruppenpolymeren immer nur langsam beschreibbar sind (weil die Mindestenergie der Zerstörungsenergie bereits sehr nahekommt) und deswegen für eine serielle Speicherung in Echtzeit ungeeignet erscheinen. Dieser prinzipielle Nachteil stand der technischen Verwendung bisher entgegen, und es ist Aufgabe der vorliegenden Erfindung, diesem Mangel abzuhelfen.

Wir haben nun überraschend gefunden, daß man extrem schnell adressierbare Speichermedien aus den an sich langsam fotoadressierbaren Polymeren dadurch herstellen kann, daß man die Substrate großflächig mit einer für das konventionelle Beschreiben geeigneten Lichtquelle bestrahlt, so daß sich eine optische Anisotropie ausbildet. Optische Anisotropie bedeutet, daß die Ausbreitungsgeschwindigkeit des Lichts in der Schichtebene richtungsabhängig ist. Dies verursacht richtungsabhängige Brechzahlen, die sog. Doppelbrechung. Wenn man die so vorbereiteten Substrate mit entsprechend intensivem Licht kurzzeitig bestrahlt, wird die Doppelbrechung extrem rasch und dauerhaft variiert, d.h. vermindert oder ganz gelöscht. Je nach Lichtintensität kann der Grad der restlichen Doppelbrechung eingestellt werden.

Es gibt also zwei optische Prozesse, die sich in ihrer Wirkung unterscheiden:
In einem generativen ersten Prozeß muß die Schicht zuerst flächig anisotrop doppelbrechend werden. Die Doppelbrechung (optische Anisotropie) wird üblicherweise als Differenz $\Delta n$ der maximalen, richtungsabhängigen Brechzahlen n bei einer bestimmten Wellenlänge angegeben.

Für das Generieren der großflächigen anisotropen Doppelbrechung ist jede Lichtquelle für polarisiertes Licht geeignet, beispielsweise eine Glühlampe mit einer nachgeschalteten Polarisatorfolie oder vorzugsweise ein Laser. Der Zeitaufwand hängt wesentlich nur von der Leistungdichte der Lichtquelle ab, wobei im Augenblick dafür keine Untergrenze bekannt ist. Die Obergrenze der Leistungsdichte der Lichtquelle wird von der Zerstörungsschwelle des Materials bestimmt; sie ist materialabhängig und liegt im Bereich von $10^7$ bis $10^8$ mW/$m^2$. Das Material kann großflächig strukturlos oder selektiv, beispielsweise über eine Maske, adressiert werden; jedoch ist die strukturlose Adressierung bevorzugt - insbesondere eine solche, die sich über die gesamte Substratfläche erstreckt. Die für die Zwecke der Erfindung notwendige optische Anisotropie $\Delta n$ des ersten Prozesses kann sehr klein sein; Voraussetzung ist lediglich, daß sie noch meßbar ist. Vorzugsweise beträgt die im ersten Prozeß erzeugte Anisotropie $\Delta n$ mindestens 0,001, insbesondere mindestens 0,005; sie beträgt vorzugsweise maximal 0,95, insbesondere maximal 0,8.

Der zweite optische Prozeß betrifft die Verwendung der im ersten optischen Prozeß vorbereiteten Substrate und besteht in der Adressierung des anisotrop doppelbrechend gemachten Materials mit Licht sehr kurzer Dauer. Das einschreibende Licht hat jetzt eine andere Qualität: Es kann polarisiert oder unpolarisiert sein. Bevorzugt ist polarisiertes Licht, dessen Achse der des Substrats parallel liegt. Die Energiedichte soll in der Regel $10^3$ bis $10^7$, vorzugsweise $10^5$ bis $6\cdot10^6$ mJ/$m^2$ betragen. "Kurzzeitig" bedeutet, daß die Lichteinwirkung $10^{-15}$ bis $10^{-3}$, vorzugsweise $10^{-10}$ bis $10^{-5}$ sec dauern kann. Entsprechend schnell muß die Lichtquelle sein, so daß Laserlichtquellen bevorzugt sind. Mit dieser Methode sind sequentielle Schreibgeschwindigkeiten bis zu 100 MHz, vorzugsweise 5 bis 50 MHz möglich. Die sequentielle Adressierung bewirkt, daß im Material die Aufnahme des Photons zwar sehr schnell erfolgt, aber danach genügend Zeit für eine Dunkelreaktion zur Verfügung steht.

Die Löschung kann großflächig erfolgen, so daß ein unstrukturiertes Muster entsteht. Bevorzugt sind aber Muster mit Strukturen, die in Richtung ihrer geringsten Ausdehnung einen Durchmesser von 10 nm bis 20 μm, insbesondere 10 nm bis 1 μm besitzen.

Die eingeschriebene Information ist stabil, d.h. nach dem Abschalten der Lichtquelle erhält man ein lagerfähiges Doppelbrechungsmuster, das mit Hilfe von polarisiertem Licht gelesen werden kann. Die Helligkeitsänderung ist der Wirkung des Lichts proportional. Das Material ist graustufenfähig. Die eingeschriebene Information ist reversibel, d.h. man kann die Information wieder löschen und anschließend neu einschreiben.

Gegenstand der Erfindung ist die Verwendung von fotoadressierbaren Polymere, die an einer als Rückgrat wirkenden Hauptkette Seitenketten unterschiedlicher Art tragen, die beide elektromagnetische Strahlung (mindestens für die eine Art: vorzugsweise die Wellenlänge des sichtbaren Lichts) absorbieren können mit der Maßgabe, dass die Absorptionsmaxima der unterschiedlichen Seitenketten mindestens 200 und maximal 10 000 $cm^{-1}$ voneinander entfernt sind, zum Speichern von Informationen in Flächengebilde, wobei zunächst eine optische Anisotropie $\Delta n$ von 0,001 bis 0,95 erzeugt wird und anschließend durch Bestrahlung mit Licht einer Energiedichte von $10^3$ bis $10^7$ mJ/$m^2$ während einer Zeitdauer von $10^{-3}$ bis $10^{-15}$ sec die optische Anisotropie gezielt partiell variiert wird und so die optische Information gespeichert wird.

Der Begriff "optisch anisotrop" im Sinne der Erfindung bedeutet eine Differenz $\Delta n$ der maximalen, richtungs-

abhängigen Brechzahlen von mindestens 0.001 bei einer Wellenlänge, die 30 nm kürzerwellig liegt als der Punkt, bei dem die Absorption in der langwelligen Flanke des längstwelligen Absorptionsmaximums noch 1 % beträgt (Absorptionsmaximum = 100 %). Angestrebt werden möglichst hohe Anisotropiewerte, weil sie gute Ergebnisse auch noch bei sehr geringen Schichtdicken zulassen. Bevorzugte Werte von $\Delta n$ liegen im Bereich von 0.05 bis 0.95, insbesondere von 0.1 bis 0.8.

Weiterer Gegenstand der Erfindung sind Polymere, in denen durch Vorbehandlung eine optische Anisotropie erzeugt werden kann, die durch Belichten während einer Zeitdauer von $10^{-3}$ bis $10^{-15}$ sec. variiert werden kann.

Für die Herstellung der fotoadressierbaren Substrate sind Polymere geeignet, in die sich eine gerichtete Doppelbrechung einschreiben läßt (Polymers as Electroopticcal and Photooptical Active Media, V. P. Shibaev (Hrsg.), Springer Verlag, New York 1995; Natansohn et al., Chem. Mater. 1993, 403-411). Insbesondere sind dies Seitengruppenpolymere, von denen die Copolymeren bevorzugt sind. Bevorzugte derartige Copoly-mere werden beispielsweise in den DE-A 3810722 und 44 34 966 beschrieben. Sie enthalten vorzugsweise eine als Rückgrat wirkende Poly(meth) acrylat-Hauptkette mit wiederkehrenden Einheiten

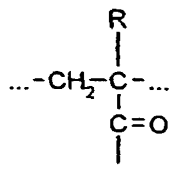

worin R für Wasserstoff oder Methyl steht, die Punkte die Anknüpfung der weiteren Einheiten der Hauptkette andeuten und die Seitenkette an die Carbonylgruppe angeknüpft ist .

Weiterer Gegenstand sind Polymere mit Seitenketten der nachfolgend beschriebenen Strukturen.

Die von der Hauptkette abzweigenden Seitenketten können den Formeln

$$-S^1\text{-}T^1\text{-}Q^1\text{-}A \qquad (I)$$

und

$$-S^2\text{-}T^2\text{-}Q^2\text{-}M \qquad (II)$$

entsprechen, worin

- $S^1$, $S^2$ unabhängig voneinander die Atome O, S oder den Rest $NR^1$,
- $R^1$ Wasserstoff oder $C_1$-$C_4$-Alkyl,
- $T^1$, $T^2$ unabhängig voneinander den Rest $(CH_2)_n$, der gegebenenfalls durch -O-, $-NR^1-$ oder $-OSiR^1_2O-$ unterbrochen und/oder durch Methyl oder Ethyl substituiert sein kann,
- n die Zahlen 2, 3 oder 4,
- $Q^1$, $Q^2$ einen zweibindigen Rest,
- A eine Einheit, die elektromagnetische Strahlung absorbieren kann, und
- M eine polarisierbare aromatische Gruppe mit wenigstens 12 $\pi$-Elektronen

bedeuten.

Besonders bevorzugt sind Polymere, in denen

$Q^1$, $Q^2$ unabhängig voneinander $Z^1$, $Z^2$ oder die Gruppe $-Z^1\text{-}X\text{-}Z^2-$ bedeutet, worin
$Z^1$, $Z^2$ unabhängig voneinander die Gruppen -S-, $-SO_2-$, -O-, -COO-, -OCO-, $-CONR^1-$, $-NR^1CO-$, $-NR^1-$, -N=N-,

-CH=CH-, -N=CH-, -CH=N- oder die Gruppe $-(CH_2)_m-$ mit m = 1 oder 2 und
X einen 5- oder 6-gliedrigen cycloaliphatischen, aromatischen oder heterocyclischen Ring, für den Fall $Z^1$ = -COO- oder $-CONR^1-$ eine direkte Bindung oder die Gruppe $-(CH=CH)_m-$,

wobei m die oben angegebenen Bedeutung hat,

A den Rest eines Mono-Azofarbstoffs, der im Wellenlängenbereich zwischen 650 und 340 nm absorbiert, und
M den Rest eines polarisierten und weiter polarisierbaren aromatischen, linear aufgebauten Systems mit wenigstens 12 $\pi$-Elektronen bedeuten.

Bevorzugte Reste A entsprechen der Formel

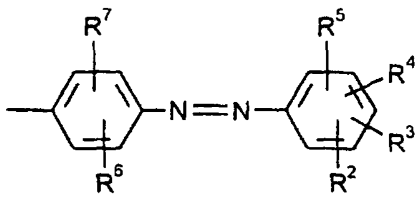

worin
$R^2$ bis $R^7$ unabhängig voneinander Wasserstoff, Hydroxyl, Halogen, Nitro, Cyan, $C_1$-$C_4$-Alkyl, $C_1$-$C_4$-Alkoxy, $CF_3$, $CCl_3$, $CBr_3$, $SO_2CF_3$, $C_1$-$C_6$-Alkyl-sulfonyl, Phenylsulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl oder $COOR^1$ bedeuten.

Bevorzugte Reste M entsprechen der Formel

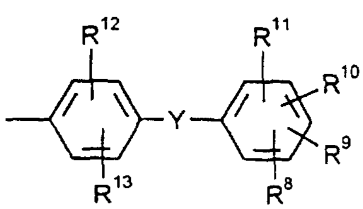

worin

$R^8$ bis $R^{13}$ unabhängig voneinander Wasserstoff, Hydroxyl, Halogen, Nitro, Cyan, $C_1$-$C_4$-Alkyl, $C_1$-$C_4$-Alkoxy, $CF_3$, $CCl_3$, $CBr_3$, $SO_2CF_3$, $C_1$-$C_6$-Alkyl-sulfonyl, Phenylsulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl oder $COOR^1$ und

Y -COO-, -OCO-, -CONH-, -NHCO-, -O-, -NH-, $-N(CH_3)-$ oder eine Einfachbindung

bedeuten.

Bevorzugt sind amorphe Polymere, also solche, die keine makroskopisch wahrnehmbaren flüssigkristallinen Phasen ausbilden. "Amorph" bedeutet einen optisch isotropen Zustand. Solche Polymeren streuen weder das sichtbare Licht noch besitzen sie eine Doppelbrechung.

Die Verbindungen können auf an sich bekannte Weise durch Copolymerisation von Mesogen- und Farbstoff-haltigen Monomeren, durch polymeranaloge Reaktion oder durch Polykondensation hergestellt werden. Bevorzugt ist die radikalische Copoly-merisation der Monomeren, d.h. der Monomeren mit mesogenen Gruppen einerseits und Farbstoff-haltigen Gruppen andererseits in geeigneten Lösungsmitteln, wie z.B. aromatischen Kohlenwasserstoffen wie Toluol oder Xylol, aromatischen Halogenkohlenwasserstoffen wie Chlorbenzol, Ethern wie Tetrahydrofuran und Dioxan, Ketonen wie Aceton und Cyclohexanon und/oder Amiden wie Dimethylformamid, in Gegenwart üblicher radikalliefernder Polymerisationsinitiatoren, wie z.B. Azodiiso-butyronitril oder Benzoylperoxid bei erhöhten Temperaturen, beispielsweise bei 30 bis 130°C, vorzugsweise bei 40 bis70°C, möglichst unter Wasser- und Luftausschluß. Die Reinigung kann durch Ausfällen bzw. Umfällen der erhaltenen Seitenketten-copolymerisate aus ihren Lösungen, beispielsweise

mit Methanol.

Während die Gruppen, die elektromagnetische Strahlung absorbieren können, in der Regel im Wellenlängenbereich des sichtbaren Lichts absorbieren, besitzen die mesogenen Gruppen bislang bekannt gewordener Seitengruppenpolymerer ein deutlich kurzwelligeres Absorptionsmaximum, vorzugsweise bei Wellenzahlen um 33 000 $cm^{-1}$; die erreichbaren Doppelbrechungsänderungen liegen unter 0,1. Die bisher beschriebenen Verfahren zur Speicherung von Information durch Doppelbrechungsänderungen sind regelmäßig als reversibel beschrieben worden, d.h. daß mit einer durch Licht oder Wärme hervorgerufenen Temperaturerhöhung die gespeicherte Information wieder gelöscht werden kann; die Verwendung von Licht kann dabei den Vorteil der lokal begrenzten Löschbarkeit bieten, weswegen diese Variante manchmal bevorzugt ist. Die prinzipielle Löschbarkeit durch Zuführung von Energie in Form von Wärme beinhaltet natürlich gleichzeitig das Risiko mangelnder Thermostabilität der eingeschriebenen Information; in der Tat ist dies ein Nachteil des bislang bekannten Standes der Technik. Viele Verbindungen dieser Art besitzen also den Nachteil, daß die eingeschriebenen Doppelbrechungen nicht temperaturstabil sind; bei höheren Temperaturen, insbesondere bei Annäherung an die Glasübergangstemperatur, wird die Doppelbrechung schwächer und verschwindet schließlich ganz. Vorteilhafte Informationsträger sind also solche, bei denen die Stabilität der eingeschriebenen Information möglichst temperatur<u>un</u>empfindlich ist.

Es wurde gefunden, daß überlegene Seitenkettenpolymere dann entstehen, wenn man die Seitenketten so auswählt, daß ihre Absorptionsmaxima einen definierten Abstand voneinander aufweisen. In diese neuen Polymeren läßt sich mit Licht Information einschreiben, die hoch thermostabil ist.

Weiterer Gegenstand der Erfindung sind also Polymere, die an einer als Rückgrat wirkenden Hauptkette Seitenketten unterschiedlicher Art tragen, die beide elektromagnetische Strahlung (mindestens für die eine Art: vorzugsweise der Wellenlänge des sichtbaren Lichts) absorbieren können mit der Maßgabe, daß die Absorptionsmaxima der unterschiedlichen Seitenketten mindestens 200, vorzugsweise mindestens 500, und maximal 10 000, vorzugsweise maximal 9000 $cm^{-1}$ voneinander entfernt sind.

Bevorzugte erfindungsgemäße Polymere tragen an einer als Rückgrat wirkenden Hauptkette davon abzweigende kovalent gebundene Seitengruppen der Formeln

$$-S^1-T^1-Q^1-A \qquad (I)$$

und

$$-S^2-T^2-Q^2-P \qquad (II),$$

worin

$S^1$, $S^2$ unabhängig voneinander Sauerstoff, Schwefel oder $NR^1$,

$R^1$ Wasserstoff oder $C_1$-$C_4$-Alkyl,

$T^1$, $T^2$ unabhängig voneinander den Rest $(CH_2)_n$, der gegebenenfalls durch -O-, $-NR^1-$ oder $-OSiR^1_2O-$ unterbrochen und/oder gegebenenfalls durch Methyl oder Ethyl substituiert sein kann,

n die Zahlen 2, 3 oder 4,

$Q^1$, $Q^2$ unabhängig voneinander einen zweibindigen Rest,

A, P unabhängig voneinander eine Einheit, die elektromagnetische Strahlung aufnehmen kann,

bedeuten mit der Maßgabe, daß die Absorptionsmaxima der Reste $-Q^1-A$ und $-Q^2-P$ mindestens 200, vorzugsweise mindestens 500 und maximal 10 000, vorzugsweise maximal 9000 $cm^{-1}$ voneinander entfernt sind.

Ein wesentliches Merkmal der Erfindung ist die Erkenntnis, daß die Eigenschaften der erfindungsgemäßen Polymeren umso besser sind, je ähnlicher die endständigen Gruppen $-Q^1-A$ und $-Q^2-P$ einander werden. Dies gilt insbesondere im Hinblick auf ihre elektronische Konfiguration. Die Übereinstimmung der Orbitalsymmetrie der beiden Gruppen soll groß, aber nicht 100 % sein. Durch die Anregung der längerwellig absorbierenden Gruppe in den ersten angeregten elektronischen ($^1S_0$)-Zustand werden die Orbitalsymmetrien der Gruppen A und P näherungsweise antisymmetrisch.

Die Funktion der Reste $T^1$ und $T^2$ besteht in der Gewährleistung eines bestimmten Abstandes der Seitengruppenenden von der als Rückgrat wirkenden Kette. Sie werden deshalb auch "Spacer" genannt.

Die Reste $Q^1$ und $Q^2$ verbinden die Endgruppen A bzw. P mit den Spacern $T^1$ bzw. $T^2$, die ihrerseits über das Verbindungsglied $S^1$ bzw. $S^2$ die Verbindung zur Hauptkette herstellen. Das besondere der Gruppen $Q^1$ und $Q^2$ ist ihr Einfluß sowohl auf A und P einerseits als auch auf $T^1$ und $T^2$ andererseits. Den Resten $Q^1$ und $Q^2$ kommt deshalb ganz besondere Bedeutung zu: So kann eine Ähnlichkeit der Konfiguration, gepaart mit einer relativ ähnlichen Lage der Absorptionsmaxima von -$Q^1$-A und -$Q^2$-P beispielsweise dadurch erreicht werden, daß identische Reste A und P durch unterschiedliche Reste $Q^1$ und $Q^2$ unterschiedlich stark polarisiert werden.

Bevorzugte Reste $Q^1$ und $Q^2$ umfassen unabhängig voneinander die Gruppen -S-, -$SO_2$-, -O-, -COO-, -OCO-, -$CONR^1$-, -$NR^1CO$-, -$NR^1$-, $(CH_2)_m$ mit m = 1 oder 2, einen zweibindigen 6-Ring mit gegebenenfalls 1 bis 2 N-Atomen (wobei dann die Anknüpfung an die Reste $T^1$ und A bzw. $T^2$ und P über diese N-Atome erfolgt) und die Gruppe $Z^1$-X-$Z^2$, worin

$Z^1$, $Z^2$ unabhängig voneinander die Gruppen -S-, -$SO_2$-, -O-, -COO-, -OCO-, -$CONR^1$-, -$NR^1CO$-, -$NR^1$-, -N=N-, -CH=CH-, -N=CH-, -CH=N- oder die Gruppe -$(CH_2)_m$- mit m = 1 oder 2 und

X den Naphthalinrest, einen 5- oder 6-gliedrigen cycloaliphatischen, aromatischen oder heterocyclischen Ring, die Gruppe -$(CH{=}CH)_m$- mit m = 1 oder 2 oder eine direkte Bindung bedeuten.

Besonders bevorzugte Reste X umfassen 2,6-Naphthylen und 1,4-Phenylen und heterocyclische Reste der Strukturen

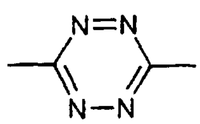
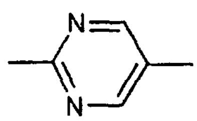
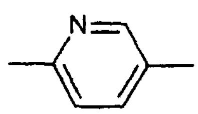
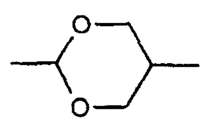

Steht X für ein 5-gliedriges Ringsystem, so kann dies carbocyclisch oder - bevorzugt - heteroaromatisch sein und bis zu 3 Heteroatome, vorzugsweise aus der Reihe S, N, O, enthalten. Geeignete Vertreter sind beispielsweise Thiophen, Thiazol, Oxazol, Triazol, Oxadiazol und Thiadiazol. Heterocyclen mit 2 Heteroatomen sind besonders bevorzugt.

Wenn X für die Gruppe -$(CH{=}CH)_m$- steht, hat m vorzugsweise den Wert 1.

Steht X für eine direkte Bindung, gelangt man beispielsweise zu Oxalsäure- oder Harnstoffderivaten oder zu Carbamaten (Z ausgewählt aus $Z^1$ und $Z^2$).

Die bevorzugten Bedeutungen von $Z^1$-X-$Z^2$ sind Benzoesäureamid- und Benzoesäureesterreste des Typs -O-$C_6H_4$-COO-, -O- $C_6H_4$-CO-$NR^1$-, -$NR^1$-$C_6H_4$-COO-, -$NR^1$-$C_6H_4$-CO-$NR^1$- sowie Fumarsäureester- und -amidreste des Typs -OCO-CH=CH-OCO- und -$NR^1$-CO-CH=CH-CO-$NR^1$-.

Besonders bevorzugt stehen $Q^1$ für die Gruppen -$Z^1$-$C_6H_4$-N=N- und $Q^2$ für die Gruppe -$Z^1$-$C_6H_4$-CO-NH-.

Die Gruppen -$Q^1$-A sollen Absorptionsmaxima im Wellenzahlenbereich von 15 000 bis 28 000 $cm^{-1}$ und die Gruppen -$Q^2$-P sollen Absorptionsmaxima im Wellenzahlenbereich von 16 000 bis 29 000 $cm^{-1}$ besitzen. Für die Zwekke der vorliegenden Erfindung werden A und P sowie $Q^1$ und $Q^2$ so definiert, daß die längerwellig absorbierende Einheit -$Q^1$-A, die kürzerwellig absorbierende Einheit -$Q^2$-P genannt wird.

Bevorzugte Reste A und P umfassen ein- und mehrkernige Reste, wie z.B. Zimtsäure-, Biphenyl-, Stilben- und Azofarbstoffreste, Benzoesäureanilide oder Analoga heterocyclischer Art, vorzugsweise Monoazofarbstoffreste.

Besonders bevorzugte Reste A und P entsprechen der Formel

$$-E-N{=}N-G \qquad (III)$$

worin

G einen einbindigen aromatischen oder heterocyclischen Rest und

E einen zweibindigen aromatischen oder heterocyclischen Rest bedeuten.

Für E geeignete aromatische Reste enthalten vorzugsweise 6 bis 14 C-Atome im aromatischen Ring, der

durch $C_1$-$C_{12}$-Alkyl, $C_1$-$C_{12}$-Alkoxy, Hydroxy, Halogen (insbesondere F, Cl, Br), Amino, Nitro, Trifluormethyl, Cyan, Carboxy, COOR (R = $C_1$-$C_6$-Alkyl, Cyclohexyl, Benzyl, Phenyl), $C_5$-$C_{12}$-Cycloalkyl, $C_1$-$C_{12}$-Alkylthio, $C_1$-$C_6$-Alkylsulfonyl, $C_6$-$C_{12}$-Arylsulfonyl, Aminosulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl, $C_1$-$C_4$-Alkylamino, Di-$C_1$-$C_4$-alkylamino, Phenylamino, $C_1$-$C_5$-Acylamino, $C_1$-$C_4$-Alkylsulfonylamino, Mono- oder Di- $C_1$-$C_4$-alkylaminocarbonylamino, $C_1$-$C_4$-Alkoxycarbonylamino oder Trifluormethylsulfonyl ein- oder mehrfach substituiert sein kann.

Für E geeignete heterocyclische Reste enthalten vorzugsweise 5 bis 14 Ringatome, von denen 1 bis 4 Heteroatome aus der Reihe Stickstoff, Sauerstoff, Schwefel sind, wobei das heterocyclische Ringsystem durch $C_1$-$C_{12}$-Alkyl, $C_2$-$C_{12}$-Alkoxy, Hydroxy, Halogen (insbesondere F, Cl, Br), Amino, Nitro, Trifluormethyl, Cyan, Carboxy, COOR (R = $C_1$-$C_6$-Alkyl, Cyclohexyl, Benzyl, Phenyl), $C_5$-$C_{12}$-Cycloalkyl, $C_1$-$C_{12}$-Alkylthio, $C_1$-$C_6$-Alkylsulfonyl, $C_6$-$C_{12}$-Arylsulfonyl, Aminosulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl, $C_1$-$C_4$-Alkylamino, Di-$C_1$-$C_4$-alkylamino, Phenylamino, $C_1$-$C_5$-Acylamino, $C_1$-$C_4$-Alkylsulfonylamino, Mono- oder Di- $C_1$-$C_4$-alkylaminocarbonylamino, $C_1$-$C_4$-Alkoxycarbonylamino oder Trifluormethylsulfonyl ein- oder mehrfach substituiert sein kann.

Für G geeignete aromatische Reste enthalten vorzugsweise 6 bis 14 C-Atome im aromatischen Ring, der durch $C_1$-$C_{12}$-Alkyl, $C_1$-$C_{12}$-Alkoxy, Hydroxy, Halogen (insbesondere F, Cl, Br), Amino, Nitro, Trifluormethyl, Cyan, Carboxy, COOR (R = $C_1$-$C_6$-Alkyl, Cyclohexyl, Benzyl, Phenyl), $C_5$-$C_{12}$-Cycloalkyl, $C_1$-$C_{12}$-Alkylthio, $C_1$-$C_6$-Alkylsulfonyl, $C_6$-$C_{12}$-Arylsulfonyl, Aminosulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl, $C_1$-$C_4$-Alkylamino, Di-$C_1$-$C_4$-alkylamino, Phenylamino, $C_1$-$C_5$-Acylamino, $C_6$-$C_{10}$-Aryl-carbonylamino, Pyridylcarbonylamino, $C_1$-$C_4$-Alkylsulfonylamino, $C_6$-$C_{12}$-Arylsulfonylamino, Mono- oder Di- $C_1$-$C_4$-alkylaminocarbonylamino, $C_1$-$C_4$-Alkoxycarbonylamino oder Trifluormethylsulfonyl ein- oder mehrfach substituiert sein kann.

Für G geeignete heterocyclische Reste enthalten vorzugsweise 5 bis 14 Ringatome, von denen 1 bis 4 Heteroatome aus der Reihe Stickstoff, Sauerstoff, Schwefel sind, wobei das heterocyclische Ringsystem durch $C_1$-$C_{12}$-Alkyl, $C_1$-$C_{12}$-Alkoxy, Hydroxy, Halogen (insbesondere F, Cl, Br), Amino, Nitro, Trifluormethyl, Cyan, Carboxy, COOR (R = $C_1$-$C_6$-Alkyl, Cyclohexyl, Benzyl, Phenyl), $C_5$-$C_{12}$-Cycloalkyl, $C_1$-$C_{12}$-Alkylthio, $C_1$-$C_6$-Alkylsulfonyl, $C_6$-$C_{12}$-Arylsulfonyl, Aminosulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl, $C_1$-$C_4$-Alkylamino, Di-$C_1$-$C_4$-alkylamino, Phenylamino, $C_1$-$C_5$-Acylamino, $C_1$-$C_4$-Alkylsulfonylamino, Mono- oder Di- $C_1$-$C_4$-alkylaminocarbonylamino, $C_1$-$C_4$-Alkoxycarbonylamino oder Trifluormethylsulfonyl ein- oder mehrfach substituiert sein kann.

Sofern die Reste E oder G mehrfach substituiert sind, richtet sich die Anzahl der Substituenten jeweils nach der Anzahl der möglichen Substitutionspositionen, der Möglichkeit des Einbaus der Substituenten und den Eigenschaften der substituierten Systeme. Die Aryl- und Acylreste können gegebenenfalls durch Nitro, Cyano, Halogen, $C_1$-$C_4$-Alkoxy, Amino substituiert sein.

Besonders bevorzugte Reste -E-N=N-G enthalten entweder einen aromatischen Rest und einen heterocyclischen Rest (d.h. entweder E oder G sind aromatisch, der andere Rest heterocyclisch) oder zwei aromatische Reste (d.h. sowohl E als auch G sind aromatisch).

Die bevorzugten Reste -E-N=N-G sind Azobenzolreste der Formel

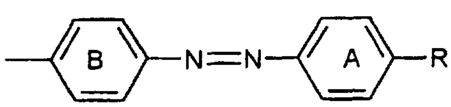

(IV)

worin

R für Nitro, Cyano, Benzamido, p-Chlor-, p-Cyano-, p-Nitrobenzamido oder Dimethylamino steht und die Ringe A und B zusätzlich substituiert sein können.

Besonders bevorzugte Reste A und P entsprechen der Formel

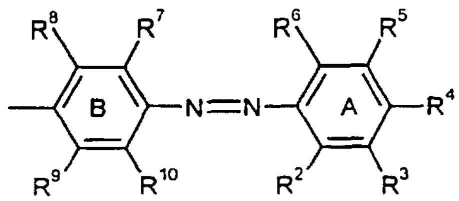

(V)

worin

$R^2$ bis $R^6$ unabhängig voneinander für Wasserstoff, Chlor, Brom, Trifluormethyl, Methoxy, $SO_2CH_3$, $SO_2CF_3$, $SO_2NH_2$, $N(CH_3)_2$, vorzugsweise Nitro, Cyano oder p-Chlor-, p-Cyano-, p-Nitrobenzamido stehen mit der Maßgabe, daß mindestens einer dieser Reste ungleich Wasserstoff ist, und

$R^7$ bis $R^{10}$ unabhängig voneinander Wasserstoff, Chlor oder Methyl bedeuten.

Bei Mehrfachsubstitution des Rings A sind die 2,4- und 3,4-Positionen bevorzugt.

Andere bevorzugte Reste A und P entsprechen der Formel

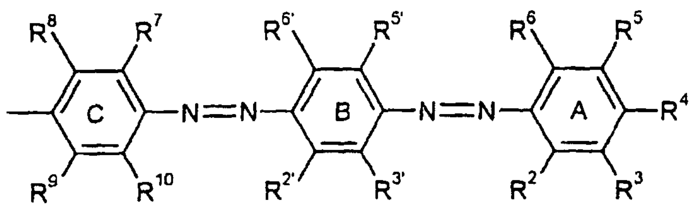

(VI)

worin

$R^2$ bis $R^6$ und $R^7$ bis $R^{10}$ die oben angegebenen Bedeutungen besitzen und

$R^2$ bis $R^{6'}$ die Bedeutungen von $R^2$ bis $R^6$ - aber unabhängig von diesen - besitzen.

Andere bevorzugte Reste A bzw. P entsprechen der Formel

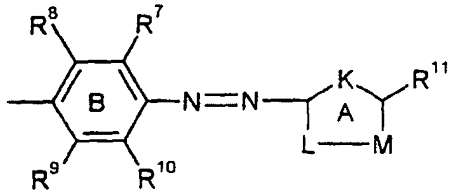

(VII)

worin

K, L, M unabhängig voneinander die Atome N, S, O oder gegebenenfalls $-CH_2-$ oder -CH= bedeuten mit der Maßgabe, daß mindestens eines der Glieder K, L, M ein Heteroatom ist und der Ring A gesättigt ist oder 1 oder 2 Doppelbindungen enthält, und

$R^7$ bis $R^{11}$ unabhängig voneinander die oben für $R^7$ bis $R^{10}$ angegebenen Bedeutungen besitzen.

Der Ring A steht vorzugsweise für einen Thiophen-, Thiazol-, Oxazol-, Triazol-, Oxadiazol- oder Thiadiazol-

rest.

Bevorzugte Reste -$Q^1$-A und -$Q^2$-P entsprechen den Formeln

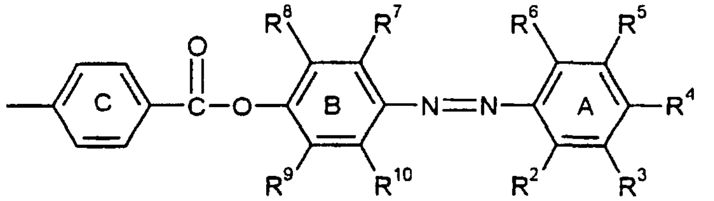

(VIII)

oder

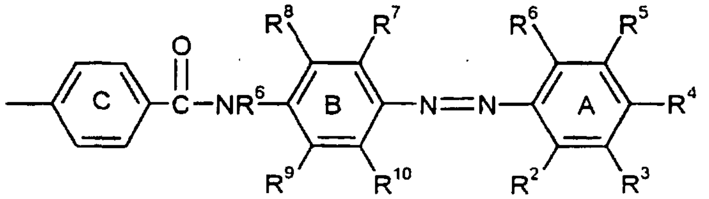

(IX)

worin

$R^1$ bis $R^{10}$ die oben angegebenen Bedeutungen besitzen.

Bevorzugte Gruppen A und P entsprechen den Formeln

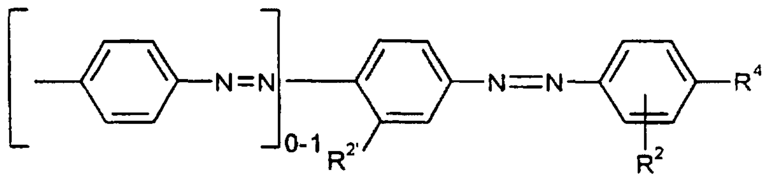

(X)

und

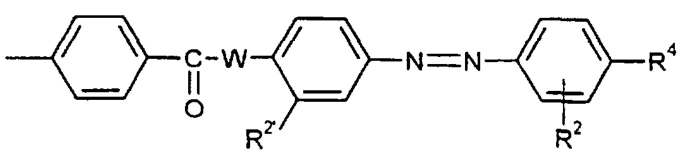

(XI)

worin

$R^2$ Wasserstoff oder Cyano,

$R^{2'}$ Wasserstoff oder Methyl,

W Sauerstoff oder $NR^1$ und

$R^4$ Nitro, Cyano, Benzamido, p-Chlor-, p-Cyano-, p-Nitrobenzamido oder Dimethylamino bedeuten.

Den obigen Formeln gemeinsam ist, daß Substitutionen in 4-, 2,4- und 3,4-Position des Ringes A besonders bevorzugt sind.

Für diese bevorzugten Gruppen A und P bevorzugte Gruppen $-S^1-T^1-Q^1-$ bzw. $-S^2-T^2-Q^2-$ entsprechen den Formel $-OCH_2CH_2O-$, $-OCH_2CH_2OCH_2CH_2O-$ und $-OCH_2CH_2-NR^1-$.

Die bevorzugten erfindungsgemäßen Polymeren enthalten allein wiederkehrende Einheiten mit den Seitengruppen I und II, und zwar vorzugsweise solche der Formeln

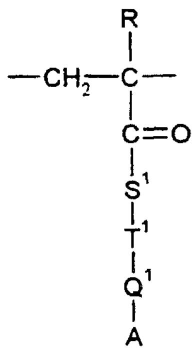

(XII)

und

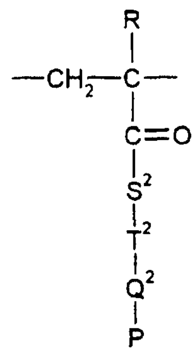

(XIII)

mit R = H oder - vorzugsweise - Methyl.

Die entsprechenden bevorzugten Monomeren zur Einführung der Seitengruppen I und II entsprechen also den Formeln

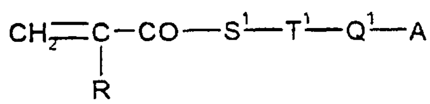

(XIV)

und

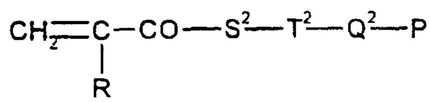

(XV).

Die Seitengruppen (I) und (II) sind also vorzugsweise an (Meth-)Acryloylgruppen $CH_2=C(R)-CO-$ mit R = Wasserstoff oder Methyl angebunden.

Vorzugsweise wird die Hauptkette der Seitengruppenpolymeren von Monomeren, die die Seitengruppen (I) tragen, von Monomeren, die die Seitengruppe (II) tragen und gegebenenfalls weiteren Monomeren gebildet, wobei insbesondere der Anteil der Monomeren, die die Seitengruppe (I) aufweisen, 10 bis 95 Mol-%, vorzugsweise 20 bis 70 Mol-%, der Anteil der Monomeren, die die Seitengruppe (II) aufweisen, 5 bis 90 Mol-%, vorzugsweise 30 bis 80 Mol-%, und der Anteil der weiteren Monomeren 0 bis 50 Mol-% betragen, jeweils bezogen auf die Summe sämtlicher eingebauter Monomereinheiten.

Als "weitere" wiederkehrende Einheiten kommen alle Bausteine in Betracht, die sich chemisch in das Seitengruppenpolymer einbauen lassen. Sie dienen im wesentlichen lediglich dazu, die Konzentration der Seitengruppen I und II im Polymer zu verringern und bewirken also quasi einen "Verdünnungs"effekt. Im Falle von Poly(meth)acrylaten umfassen die "weiteren" Monomeren ethylenisch ungesättigte copolymerisierbare Monomere, die bevorzugt $\alpha$-substituierte Vinylgruppen oder $\beta$-substituierte Allylgruppen tragen, bevorzugt Styrol; aber auch beispielsweise kernchlorierte und -alkylierte bzw. -alkenylierte Styrole,. wobei die Alkylgruppen 1 bis 4 Kohlenstoffatome und die Alkenylgruppen 2 bis 4 Kohlenstoffatome enthalten können, wie z.B. Vinyltoluol, Divinylbenzol, $\alpha$-Methylstyrol, tert.-Butylstyrole, Chlor-

styrole; Vinylester von Carbonsäuren mit 2 bis 6 Kohlenstoffatomen, bevorzugt Vinylacetat; Vinylpyridin, Vinylnaphthalin, Vinylcyclohexan, Acrylsäure und Methacrylsäure und/oder ihre Ester (vorzugsweise Vinyl-, Allyl- und Methallylester) mit 1 bis 4 Kohlenstoffatomen in der Alkoholkomponente, ihre Amide und Nitrile, Maleinsäureanhydrid, -halb- und -diester mit 1 bis 4 Kohlenstoffatomen in der Alkoholkomponente, -halb- und -diamide und cyclische Imide wie N-Methylmaleinimid oder N-Cyclohexylmaleinimid; Allylverbindungen wie Allylbenzol und Allylester, wie Allylacetat, Phthalsäurediallylester, Isophthalsäurediallylester, Fumarsäurediallylester, Allylcarbonate, Diallylcarbonate, Triallylphosphat und Triallylcyanurat.

Bevorzugte "weitere" Monomere entsprechen der Formel

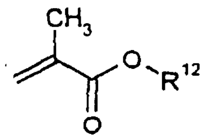

(XVI)

worin

$R^{12}$ für einen gegebenenfalls verzweigten $C_1$-$C_6$-Alkylrest oder einen wenigstens einen weiteren Acrylrest enthaltenden Rest steht.

Die erfindungsgemäßen Polymeren können auch mehr als eine Seitengruppe, die unter die Definition von (I) fällt, oder mehr als eine Seitengruppe, die unter die Definition von (II) fällt, oder mehrere Seitengruppen sowohl der Definition von (I) als auch von (II) enthalten.

Die erfindungsgemäßen Polymeren besitzen vorzugsweise Glasübergangstemperaturen Tg von mindestens 40°C. Die Glasübergangstemperatur kann beispielsweise nach B. Vollmer, Grundriß der Makromolekularen Chemie, S. 406 bis 410, Springer-Verlag, Heidelberg 1962, bestimmt werden.

Die erfindungsgemäßen Polymeren besitzen im allgemeinen ein als Gewichtsmittel bestimmtes Molekulargewicht von 3 000 bis 2 000 000, vorzugsweise 5 000 bis 1 500 000, bestimmt durch Gelpermeationschromatographie (geeicht mit Polystyrol).

Die Strukturelemente mit hoher Formanisotropie und hoher Anisotropie der molekularen Polarisierbarkeit sind die Voraussetzung für hohe Werte der optischen Anisotropie. Durch die Struktur der Polymeren werden die zwischenmolekularen Wechselwirkungen der Strukturelemente (I) und (II) so eingestellt, daß die Ausbildung flüssigkristalliner Ordnungszustände unterdrückt wird und optisch isotrope, transparente nichtstreuende Filme hergestellt werden können. Andererseits sind die zwischenmolekularen Wechselwirkungen dennoch stark genug, daß bei Bestrahlung mit polarisiertem Licht ein photochemisch induzierter, kooperativer, gerichteter Umorientierungsprozeß der Seitengruppen bewirkt wird.

In die optisch isotropen, amorphen erfindungsgemäßen Polymeren lassen sich durch Bestrahlung mit polarisiertem Licht extrem hohe Werte der optischen Anisotropie induzieren. Die gemessenen Werte der Doppelbrechungsänderung $\Delta n$ liegen zwischen 0,05 und 0,8.

Als Licht wird vorzugsweise linear polarisiertes Licht verwendet, dessen Wellenlänge im Bereich der Absorptionsbande der Seitengruppen liegt.

Weiterer Gegenstand der Erfindung sind Polymere, in die mit polarisiertem Licht Doppelbrechungsänderungen $\Delta n$ von über 0,15, vorzugsweise über 0,2, insbesondere über 0,4 eingeschrieben werden können. Die Bestimmung des Wertes $\Delta n$ soll dabei, wie nachfolgend beschrieben, erfolgen:

Zunächst bestimmt man an den beiden <u>Homo</u>polymerisaten jeweils das Absorptionsmaximum $\lambda_{max1}$ bzw. $\lambda_{max2}$. Durch Bestrahlen eines Films des zu testenden <u>Co</u>polymerisats mit linear polarisiertem Licht einer Wellenlänge von $(\lambda_{max1}+\lambda_{max2})$:2 erzeugt man eine Doppelbrechungsänderung. Dazu werden die Proben in Richtung der Flächennormalen mit polarisiertem Licht bestrahlt. Die Leistung der Lichtquelle soll 1 000 mW/cm$^2$ betragen; für den Fall, daß das Copolymerisat unter diesen Bedingungen zerstört wird, setzt man die Leistung der Lichtquelle in 100 mW-Stufen solange herab, bis das Copolymerisat durch die Bestrahlung nicht mehr zerstört wird. Die Bestrahlung wird fortgeführt, bis sich die Doppelbrechung nicht mehr ändert. Die Messung der erzeugten Doppelbrechungsänderung erfolgt mit einer Auslesewellenlänge von $[((\lambda_{max1}+\lambda_{max2}):2] + 350 \pm 50$[nm]. Die Polarisation des Meßlichts soll einen Winkel von 45°, relativ zur Polarisationsrichtung des einschreibenden Lichts, bilden.

Die Herstellung der Seitengruppenmonomeren und ihre Polymerisation können nach literaturbekannten Verfahren durchgeführt werden; vgl. beispielsweise Makromolekulare Chemie 187, 1327-1334 (1984), SU 887 574, Europ. Polym. 18, 561 (1982) und Liq. Cryst. 2, 195 (1987), DD 276 297, DE-OS 28 31 909 und 38 08 430. Die erfindungsgemäßen Polymeren werden im allgemeinen durch radikalische Copolymerisation der Monomeren in geeigneten Lösungsmitteln, wie z.B. aromatischen Kohlenwasserstoffen wie Toluol oder Xylol, aromatischen Halogenkohlenwasserstoffen wie Chlorbenzol, Ethern wie Tetrahydrofuran oder Dioxan, Ketonen wie Aceton oder Cyclohexanon, und/oder Dimethylformamid in Gegenwart radikalliefernder Polymerisationsinitiatoren, wie z.B. Azobis(isobutyronitril) oder Benzoylperoxid, bei erhöhten Temperaturen, in der Regel bei 30 bis 130°C, vorzugsweise bei 40 bis 70°C, möglichst unter Wasser- und Luftausschluß hergestellt. Die Isolierung kann durch Ausfällen mit geeigneten Mitteln, z.B. Methanol erfolgen. Die Produkte können durch Umfällen, z.B. mit Chloroform/Methanol gereinigt werden.

Weiterer Gegenstand der Erfindung ist also ein Verfahren zur Herstellung der Seitengruppenpolymeren durch Copolymerisation der entsprechenden Monomeren.

Die Polymeren werden in Schichten verarbeitet, deren Dicke 0,1 bis 500 µm, bevorzugt 1 bis 30 µm, besonders bevorzugt 2 bis 10 µm beträgt. Sie lassen sich aus Lösung gießen, rakeln, tauchen, spincoaten. Sie können selbsttragende Filme bilden. Vorzugsweise werden sie aber auf Trägermaterialien aufgebracht. Dies kann durch verschiedene an sich bekannte Techniken geschehen, wobei das Verfahren danach ausgewählt wird, ob eine dicke oder dünne Schicht gewünscht wird. Dünne Schichten können z.B. durch Spincoaten oder Rakeln aus Lösungen oder der Schmelze, dickere durch Schmelzpressen oder Extrudieren erzeugt werden.

Die Herstellung isotroper Filme gelingt, ohne daß aufwendige Orientierungsverfahren unter Nutzung externer Felder und/oder von Oberflächeneffekten notwendig sind. Sie lassen sich durch Spincoating, Tauchen, Gießen oder andere technologisch leicht beherrschbare Beschichtungsverfahren auf Unterlagen aufbringen, durch Pressen oder Einfließen zwischen zwei transparente Platten bringen oder einfach als selbsttragende Filme durch Gießen oder Extrudieren herstellen. Solche Filme lassen sich durch schlagartiges Abkühlen, d.h. durch eine Abkühlungsrate von > 100 K/min, oder durch rasches Abziehen des Lösungsmittels auch aus flüssig-kristallinen Polymeren herstellen, die Strukturelemente im beschriebenen Sinne enthalten.

Ein weiterer Gegenstand der Erfindung sind also Filme (sowohl selbsttragende als auch solche in Form von Beschichtungen) aus den beschriebenen Polymeren sowie mit diesen Filmen beschichtete Träger.

Die erfindungsgemäßen Seitengruppenpolymeren sind im glasartigen Zustand der Polymeren optisch isotrop, amorph, transparent und nicht-lichtstreuend und können selbsttragende Filme bilden.

Vorzugsweise werden sie aber auf Trägermaterialien, beispielsweise Glas oder Kunststoffolien, aufgebracht. Dies kann durch verschiedene an sich bekannte Techniken geschehen, wobei das Verfahren danach ausgewählt wird, ob eine dicke oder dünne Schicht gewünscht wird. Dünne Schichten können z.B. durch Spincoaten oder Rakeln aus Lösungen oder der Schmelze, dickere durch Füllen von vorgefertigten Zellen, Schmelzpressen oder Extrudieren erzeugt werden.

Die Polymeren lassen sich zur digitalen oder analogen Datenspeicherung im weitesten Sinne, beispielsweise zur optischen Signalverarbeitung, zur Fourier-Transformation und -Faltung oder in der kohärenten optische Korrelationstechnik, verwenden. Die laterale Auflösung wird durch die Wellenlänge des Einschreibelichts begrenzt. Sie erlaubt eine Pixelgröße von 0,45 bis 3 000 µm, bevorzugt ist eine Pixelgröße von 0,5 bis 30 µm.

Diese Eigenschaft macht die Polymeren zur Verarbeitung von Bildern und zur Informationsverarbeitung mittels Hologrammen besonders geeignet, deren Reproduktion durch Ausleuchten mit einem Referenzstrahl erfolgen kann. Analog läßt sich das Interferenzmuster zweier monochromatischer kohärenter Lichtquellen mit konstanter Phasenbeziehung speichern. Entsprechend lassen sich dreidimensionale holographische Bilder speichern. Das Auslesen erfolgt durch Beleuchtung des Hologramms mit monochromatischem, kohärentem Licht. Durch den Zusammenhang zwischen dem elektrischen Vektor des Lichts und der damit verbundenen Vorzugsrichtung im Speichermedium läßt sich eine höhere Speicherdichte als bei einem rein binären System erzeugen. Bei der analogen Speicherung können Werte der Grauskala kontinuierlich und ortsaufgelöst eingestellt werden. Das Auslesen analog gespeicherter Information geschieht im polarisierten Licht, wobei man je nach Stellung der Polarisatoren das positive oder das negative Bild hervorholen kann. Hierbei kann einerseits der durch die Phasenverschiebung von ordentlichem und außerordentlichem Strahl erzeugte Kontrast des Films zwischen zwei Polarisatoren genutzt werden, wobei die Ebenen des Polarisators vorteilhaft einen Winkel von 45° zur Polarisationsebene des Einschreiblichts bilden und die Polarisationsebene des Analysators entweder senkrecht oder parallel zu der des Polarisators steht. Eine andere Möglichkeit besteht in der Detektion des durch induzierte Doppelbrechung verursachten Ablenkwinkels des Leselichts.

Die Polymeren lassen sich als optische Komponenten verwenden, die passiv sein oder aktiv schaltbar sein können, insbesondere für holografische Optiken. So kann die hohe lichtinduzierte optische Anisotropie zur elektrischen Modulierung der Intensität und/oder des Polarisationszustandes von Licht genutzt werden. Entsprechend kann man aus einem Polymerfilm durch holografische Strukturierung Komponenten herstellen, die Abbildungseigenschaften haben, die mit Linsen oder Gittern vergleichbar sind.

Die Schichten lassen sich zur seriellen Aufzeichnung von lichtübertragenden Daten jeder Art verwenden, insbesondere von Bildern im medizinischen Bereich.

Weiterer Gegenstand der Erfindung ist also die Verwendung der optisch anisotropen Substrate in der Informationstechnik, insbesondere als Bauelemente zum Speichern und zur Verarbeitung von Informationen, vorzugsweise

von Bildern, und als holographisches Aufzeichnungsmaterial.

Die Prozentangaben in den nachfolgenden Beispielen beziehen sich - falls nicht anders angegeben -jeweils auf das Gewicht.

**Beispiele**

**Beispiel 1**

1.1 Vorbelichtung

Glasplättchen mit den Abmessungen 2x2cm wurden mit einer Lösung des Polymers mit wiederkehrenden Einheiten folgender Formeln durch Spincoaten beschichtet:

45 %

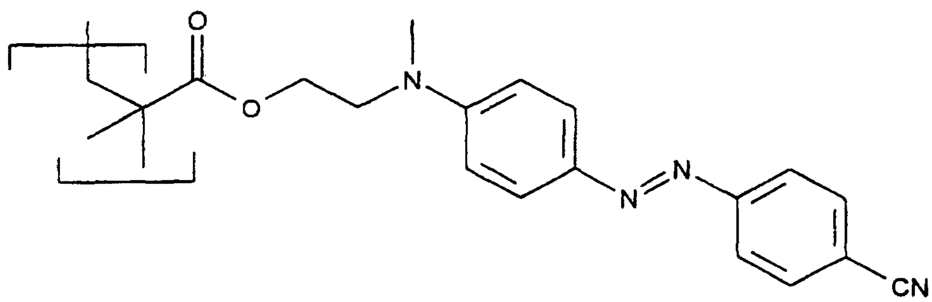

55 %

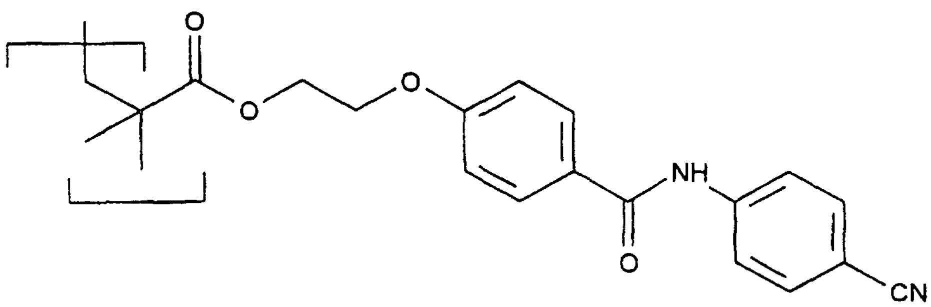

Um eine möglichst homogene Vorbelichtung zu erreichen, wurden diese an einem handelsüblichen Leuchtkasten (Planilux, Typ LJ-S, Lichtquelle: 2 Leuchtstofföhren (Leistung: je 15 Watt) mit nachgeschaltetem Folienpolarisator) vorbelichtet (Abstand: 2 cm) und danach die Transmissionwerte zwischen gekreuzten Polarisatoren bestimmt. Man erhielt nach 1 Stunde Vorbelichtung 7.6 %, nach 2 Stunden 13.7 % Transmission.

1.2. Einschreib- und Meßaufbau.

Zur Messung der eingeschriebenen Doppelbrechung dient ein Aufbau bestehend aus einem linear polarisierten He-Ne-Laser mit nachfolgender Aufweitoptik, Probenhalter, drehbarem Polarisationsfilter sowie einer Ulbricht-Kugel mit angeschlossenem Photozellen-Powermeter. Die eingeschriebenen Proben werden bezüglich der Polarisationsrichtung des He-Ne-Lasers so ausgerichtet, daß der Winkel zur Polarisationsrichtung des einschreibenden Lasers 45° beträgt. Die Durchlaßrichtung des Polarisationsfilters liegt senkrecht zur Richtung des probenden He-Ne-Lasers. In dieser Konfiguration wird die transmittierte Laserleistung als Funktion der Einschreibleistung auf dem entsprechenden Probenfeld ermittelt. Zur Normierung dient eine zusätzliche Messung der Durchlaßleistung an einer nichtbeschriebenen Probenstelle bei "offener" Stellung des Polarisationsfilters.

1.3 Einschreiben

Eingeschrieben werden ebene Flächen (Flatfields) mit dem vorstehend beschriebenem Rekorderaufbau. Die

Polarisationsrichtung des Einschreiblasers lag dabei senkrecht zur Durchlaßrichtung des zum Vorbelichten verwendeten Folienpolarisators. Die Daten des Einschreibaufbaus sind:
Laserquelle: Ar-Ionenlaser, linear polarisiert,
Single Line-Betrieb, $\lambda$ = 514.5 nm

| | |
|---|---|
| Laserleistung in der Bildebene | max 280 mW |
| Laserspotgröße | 7-8 μm |
| Pixelgröße (Zeilenabstand) | 5.4 μm |
| Scanlänge | 7.41mm |
| Scanhöhe | 5.82 mm |
| Scangeschwindigkeit (in Zeilenrichtung) | 0.6 bis 23.8 m/sec |

Die Belichtungsenergie in der Bildebene wird sowohl durch die Laserleistung in der Bildebene als auch durch die Scangeschwindigkeit bestimmt.

Man erhält folgende Änderung der Transmission mit der Energie des einschreibenden Lichts (Scangeschwindigkeit 23.8 m/sec; T = Probentransmission in %; E = Einschreibenergie in [$10^6$ mJ/$m^2$]) (s. Fig. 1).

Aus den Meßdaten lassen sich folgende Kenndaten ableiten:

| | |
|---|---|
| Totaler Dichtehub im Einschreibebereich | $\delta D = 0{,}9$ |
| Gradation im "linearen" Kurventeil | g = 1,9 |
| Energiedichte zur Erzielung von $\delta D$ | $E = 1{,}3 \times 10^6$ mJ/$m^2$ |

Die eingeschriebenen Informationen sind beim Lagern bei Raumtemperatur stabil.

**Beispiele 2-20**

Setzt man an Stelle des in Beispiel 1 eingesetzten Polymeren ein Polymer mit den unten angegebenen wiederkehrenden Einheiten ein und verfährt im übrigen wie in Beispiel 1 angegeben, so findet man:

In den Tabellen 1, 2, 3 und 4 bedeuten:

- R den Substituenten entsprechend der Formeln 2, 3, 4 oder 5,
- $\lambda$ die Wellenlänge maximaler Absorption,
- $\Delta n$ die in einem ersten Prozeß eingebrachte Doppelbrechungsänderung,
- x den Gehalt der Antennenkomponente im Copolymeren,
- E die Energie zum Einschreiben und
- $\varepsilon$ die optische Dichte bei der Einschreibwellenlänge von 514 nm.

Wiederkehrende Einheiten:

x %

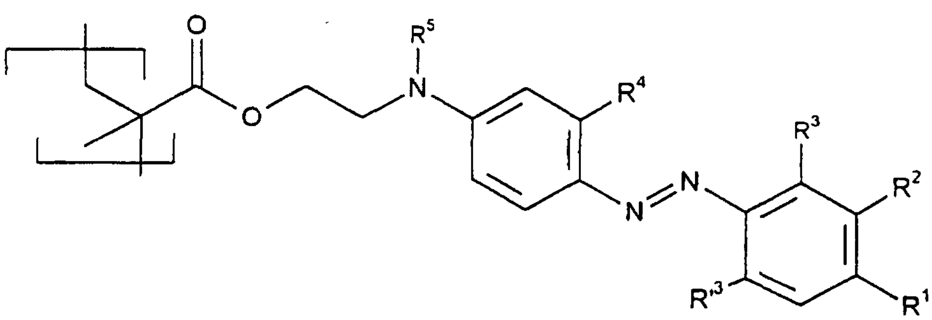

100-x %

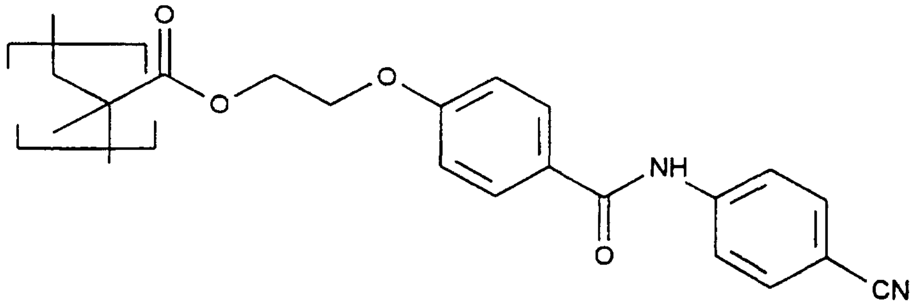

Tabelle 1

| | $R^1$ | $R^2$ | $R^3$ | $R'^3$ | $R^4$ | $R^5$ | λ | Δn | x | Tg | E | ε |
|---|---|---|---|---|---|---|---|---|---|---|---|---|
| 2 | CN | CN | H | H | CH3 | Et | 490 | 0.043 | 50 | 142 | 1.3 | 3.36 |
| 3 | CN | H | H | H | H | Me | 472 | 0.029 | 45 | 141 | 1.6 | 3.19 |
| 4 | CN | H | CN | H | H | Me | 490 | 0,077 | 50 | 144 | 1.8 | 2.5 |
| 5 | $NO_2$ | H | Cl | H | H | Me | 490 | 0.057 | 49 | 129 | 1,9 | 1,8 |
| 6 | $NO_2$ | H | H | H | H | Et | 484 | 0,060 | 48.5 | 124 | 2 | 1.76 |
| 7 | $NO_2$ | H | H | H | H | Me | 469 | 0.116 | 44 | 136 | 2.1 | 3 |
| 8 | $NO_2$ | H | H | H | H | Et | 502 | 0,022 | 50 | 131 | 2.3 | 3.4 |
| 9 | $CH_3$ | H | CN | CN | H | Me | 483 | 0,029 | 51 | 130 | 2,4 | 3,38 |
| 10 | CN | H | H | H | H | Me | 436 | 0.074 | 58 | 138 | 2.7 | 2.13 |
| 11 | CN | H | H | H | CH3 | Et | 488 | 0,03 | 50 | 134 | 2.8 | 3.43 |
| 12 | $OCH_3$ | H | H | H | H | Me | 403 | 0.048 | 75 | 118 | 3,6 | 0,24 |
| 13 | Cl | H | H | H | H | Me | 412 | 0,042 | 60 | 99 | 3,7 | 0,52 |
| 14 | CN | H | H | H | H | Me | 452 | 0,057 | 75 | 133 | 4,1 | 1.75 |
| 15 | Br | H | H | H | H | Me | 416 | 0.016 | 52 | 137 | 4.2 | 1.51 |
| 16 | $CH_3$ | H | H | H | H | Me | 408 | 0,05 | 40 | 133 | 4,3 | 0.57 |
| 17 | $OCH_3$ | H | Cl | H | H | Me | 414 | 0.032 | 50 | 133 | 4,3 | 0.3 |
| 18 | $OCH_3$ | H | H | H | H | Me | 407 | 0,079 | 45 | 128 | 4,5 | 0.2 |
| 19 | $OCH_3$ | H | H | H | H | Me | 406 | 0,041 | 60 | 123 | 4.5 | 0,24 |
| 20 | $OCH_3$ | H | H | H | H | Me | 410 | 0.028 | 28 | 132 | 5,7 | 0.19 |

**Beispiele 21 - 30**

Setzt man an Stelle des in Beispiel 1 eingesetzten Polymeren ein Polymer mit den unten angegebenen wiederkehrenden Einheiten ein und verfährt im übrigen wie in Beispiel 1 angegeben, so findet man:

Bedeutung der Tabellen-Werte siehe Beispiel 2:

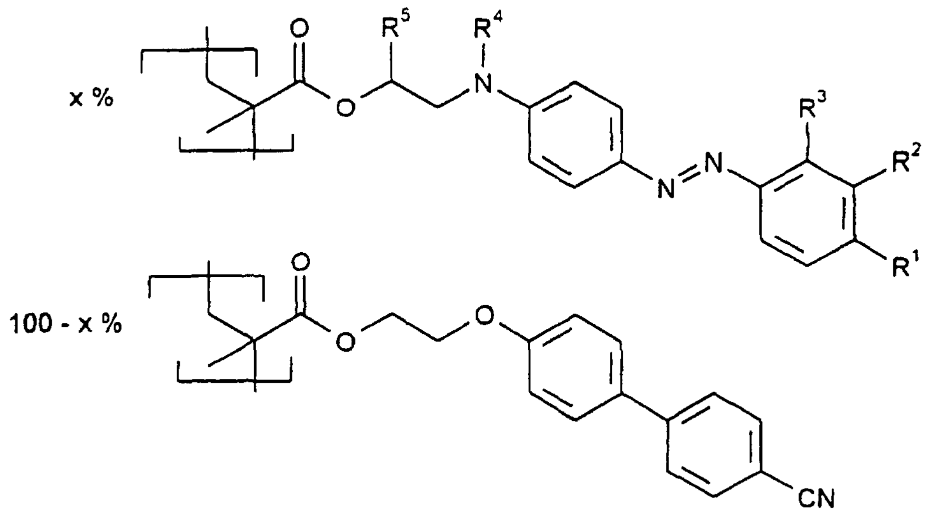

Tabelle 2

| | $R^1$ | $R^2$ | $R^3$ | $R^4$ | $R^5$ | λ | Δn | x | E | ε |
|---|---|---|---|---|---|---|---|---|---|---|
| 21 | CN | H | H | Mc | H | 439 | 0,027 | 60 | 1.2 | - |
| 22 | CN | H | CN | Me | H | 502 | 0,038 | 40 | 1,4 | 3,34 |
| 23 | CN | CN | H | Me | H | 482 | 0,032 | 40 | 2.3 | 2,24 |
| 24 | CN | H | H | Et | Me | 446 | 0,023 | 40 | 2.3 | 1,7 |
| 25 | $CF_3$ | H | H | Me | H | 420 | 0,041 | 40 | 2.4 | 0,6 |
| 26 | $SO2CF_3$ | H | H | Me | H | 460 | 0,096 | 40 | 2,5 | 1,91 |
| 27 | $OCH_3$ | H | H | Me | H | 407 | 0,034 | 40 | 3,4 | 0,2 |
| 28 | CN | H | H | Me | H | 450 | 0,029 | 40 | 4,5 | - |
| 29 | CN | H | H | Me | H | 450 | 0,024 | 40 | 4.8 | - |
| 30 | $OCH_3$ | H | H | Me | H | 412 | 0,014 | 60 | 6.6 | 0,18 |

**Beispiele 31 und 32**

Setzt man an Stelle des in Beispiel 1 eingesetzten Polymers ein Homopolymer mit den unten angegebenen wiederkehrenden Einheiten ein und verfährt im übrigen wie in Beispiel 1 angegeben, so findet man:

Bedeutung der Tabellen-Werte siehe Beispiel 2:

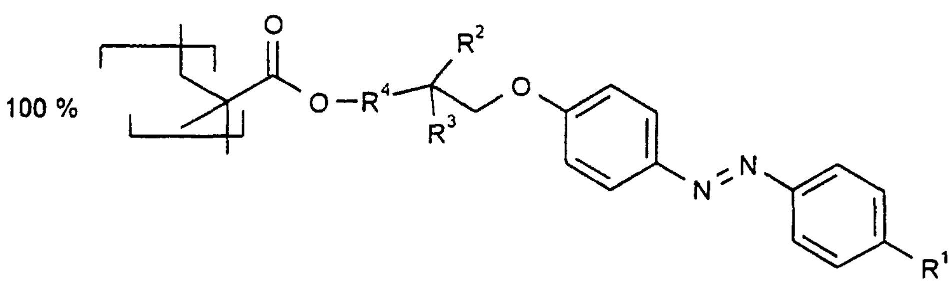

Tabelle 3

| | $R^1$ | $R^2$ | $R^3$ | $R^4$ | λ | n | x | E | ε |
|---|---|---|---|---|---|---|---|---|---|
| 31 | CN | Me | H | - | 365 | 0,055 | 100 | 3,5 | 0,2 |
| 32 | CN | Me | Me | $CH_2$ | 365 | 0,042 | 100 | 3,8 | 0.2 |

**Beispiele 33 - 36**

Setzt man an Stelle des in Beispiel 1 eingesetzten Polymers ein Polymer mit den unten angegebenen wiederkehrenden Einheiten ein und verfährt im übrigen wie in Beispiel 1 angegeben, so findet man:

Bedeutung der Tabellen-Werte siehe Beispiel 2:

x %

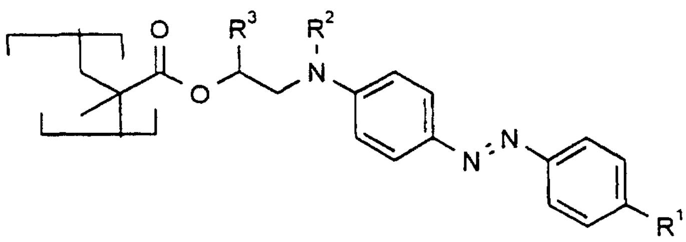

100 - x %

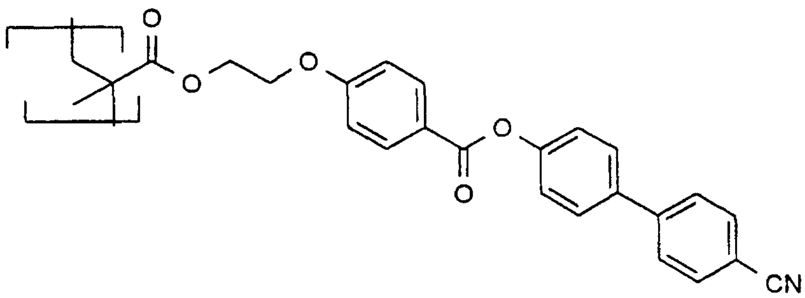

Tabelle 4

| | $R^1$ | $R^2$ | $R^3$ | λ | Δn | x | E | ε |
|---|---|---|---|---|---|---|---|---|
| 33 | CN | Et | Me | 443 | 0.042 | 60 | 1,6 | 1,1 |
| 34 | CN | Et | Me | 444 | 0,039 | 50 | 1,8 | 1,1 |
| 35 | CN | Et | Me | 446 | 0.067 | 40 | 2.2 | 0,79 |
| 36 | $CF_3$ | Me | H | 420 | 0.032 | 60 | 2,2 | 0,4 |
| 37 | $CF_3$ | Me | H | 420 | 0,022 | 70 | 3,3 | 0,4 |

**Beispiel 38**

Eine Probe, hergestellt wie in Beispiel 1 beschrieben, wird folgendem Testzyklus unterworfen:

| | |
|---|---|
| 38.1 | Vorbelichten der Probe am Leuchtkasten mit nachgeschalteter Polarisationsfolie (Belichtungszeit: 1 Stunde) |
| 38.2 | Einschreiben mit dem Rekorderaufbau bei verschiedenen Laserleistungen mit Polarisation des Schreiblasers senkrecht zur Polarisation der Vorbelichtung |
| 38.3 | Erneute Belichtung der eingeschriebenen Probe am Leuchtkasten mit nachgeschalteter Polarisationsfolie, wobei die Durchlaßrichtung des Polarisators die gleiche ist, wie bei der ersten Vorbelichtung (Belichtungszeit: 7-8 Stunden) |
| 38.4 | Einschreiben mit dem Rekorder-Aufbau unter denselben Bedingungen wie oben beschrieben. |

Transmission der Probe nach erneuter Vorbelichtung (s. Fig. 2)

Abb. 2: Probentransmission T in [%] nach erneuter Vorbelichtung in Abhängigkeit von E [$10^6$ mJ/$m^2$]:

Transmission an Stellen, an denen keine thermischen Strukturen eingeschrieben wurden: gefüllte Vierecke
Transmission an Stellen, an denen beim Einschreibprozeß thermische Strukturen erzeugt wurden: offene Vierecke

Abb. 3: Transmission der Probe nach erneutem Einschreiben in [%] in Abhängigkeit von E [$10^6$ mJ/$m^2$]

unmittelbar nach dem Einschreiben: offene Vierecke
Ausgangssituation nach der "Löschbelichtung": gefüllte Vierecke (s. Fig. 3)

Fazit:

Die eingeschriebenen Muster sind durch erneute Vorbelichtung an den Stellen, an denen keine thermischen Strukturen erzeugt wurden, vollständig löschbar. Thermisch eingeschriebene Strukturen bleiben jedoch nach der Löschbelichtung erhalten und verringern durch Streuung die Probentransmission an den entsprechenden Stellen.

Bei erneutem Schreiben ist das Verhalten der Probe äquivalent zum ursprünglichen Einschreibtest, was durch folgende Abbildung 4 verdeutlicht wird (s. Fig. 4).

Abb. 4: Normierte Probentransmission T [%] in Abhängigkeit von der Einschreib-energie E in [$10^6$ mJ/$m^2$]

Nach dem ersten Einschreiben: gefüllte Vierecke
Nach dem zweiten Einschreiben: offene Vierecke

<u>**Beispiel 39**</u>

Zwei Proben, hergestellt wie in Beispiel 1, aber aus einem Polymer mit wiederkehrenden Einheiten der Formeln

50%

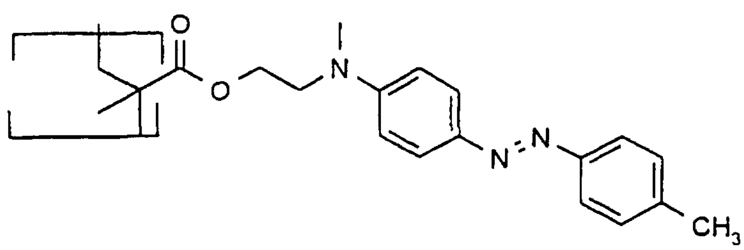

50%

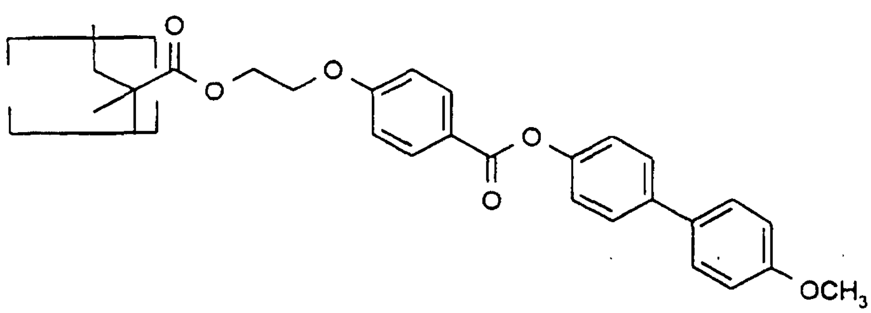

werden wie in Beispiel 1 beschrieben vorbelichtet, und zwar eine Probe bis zu einer Transmission von 49 %, die andere bis zu 61 %. Man verfährt weiter wie in Beispiel 1 beschrieben und erhält die in der folgenden Abbildung 5 dargestellte

Abnahme der Transmission in [%] mit zunehmender Einschreibenergie E in [$10^6$ mJ/$m^2$] (s. Fig. 5).

Meßwerte aus Einschreibtest "49 %-Transmission": gefüllte Vierecke
Meßwerte aus Einschreibtest "61 % Transmission": offene Vierecke

**Beispiel 40** Herstellung der Polymerisate

1.1 Herstellung der Monomeren

1.1.1 aus Methacrylchlorid

100 g N-Methyl-N-(2-hydroxyethyl)-anilin werden in 100 ml Chloroform gelöst. Man gibt bei 40°C unter Rühren tropfenweise 182,6 g Triethylamin und 137,2 g Methacrylchlorid langsam hinzu und rührt bei 40°C über Nacht. Danach versetzt man die Reaktionslösung mit 500 ml Chloroform und schüttelt 5 mal mit je 200 ml Wasser aus. Die organische Phase wird über wasserfreiem Magnesiumsulfat getrocknet, mit Kupfer(I)chlorid versetzt und nach Abdestillieren des Lösungsmittels im Hochvakuum destilliert. Der Methacrylester des Hydroxyethylanilins geht bei 127-130°C/55 mbar als wasserklare Flüssigkeit über. Die Ausbeute beträgt 49,5 g.

1.1.2 aus Methacrylsäure

In eine Lösung aus 100 ml N-Methyl-N-(2-hydroxyethyl)-anilin, 265 ml Methacrylsäure und 26,5 g Hydrochinon in 398 ml Chloroform werden bei Raumtemperatur unter Rühren 50 ml konz. Schwefelsäure getropft. Nach dem Stehen über Nacht wird aufgeheizt und das Reaktionswasser azeotrop entfernt. Nach dem Abkühlen wird mit konzentrierter wäßriger Sodalösung ein pH von 7 bis 8 eingestellt, und das Produkt wird aus dieser Lösung durch Ausschütteln mit Ether extrahiert. Man verfährt wie oben angegeben weiter und erhält eine Ausbeute von 56 g.

1.1.3 Monomer mit der Endgruppe -A

7,15 g 2,4-Dicyanoanilin werden bei 0 bis 5°C in einer Lösung aus 100 ml Eisessig, 20 ml Phosphorsäure und 7,5 ml Schwefelsäure mit 24 g Nitrosylschwefelsäure diazotiert und 1 h nachgerührt. Man gibt die Reaktionsmischung zu einer Lösung von 15,3 g N-Methyl-N-(2-methacryloyloxyethyl)-anilin und 1,5 g Harnstoff in 60 ml Eisessig, wobei die Temperatur auf 10°C gehalten wird. Nach kurzem Nachrühren wird die Reaktionsmischung mit Soda auf einen pH-Wert von 3 gestellt, der Niederschlag abgesaugt, mit Wasser gewaschen und getrocknet. Man erhält 14,4 g eines roten Feststoffs, der ohne weitere Reinigung weiter verwendet wird.

1.1.4 Monomer mit der Endgruppe -P

Zu einer Lösung von 33 g 4-(2-Methacryloyloxy)-ethoxy-benzoesäurechlorid in 100 ml Dioxan werden 27,6 g 4-Arnino-2',4'-dicyano-azobenzol in 500 ml Dioxan gegeben, 2 h gerührt und das Produkt durch Eingießen der Lösung in 2 1 Wasser gefällt. Der Niederschlag wird abgesaugt, getrocknet und durch zweimaliges Umkristallisieren aus Dioxan gereinigt. Die Ausbeute beträgt 30,4 g an orangeroten Kristallen mit einem Fp. von 215- 217°C.

1.2 Herstellung des Copolymerisats

2,7 g Monomer 1.1.3 und 5,19 g Monomer 1.1.4 werden in 75 ml DMF unter Argon als Schutzgas mit 0,39 g Azobis(isobutyronitril) als Polymerisationsinitiator bei 70°C zur Polymerisation gebracht. Nach 24 h wird filtriert, das DMF abdestilliert, der Rückstand zur Entfernung nicht umgesetzter Monomerer mit Methanol ausgekocht und bei 120°C im Hochvakuum getrocknet. Man erhält 7,18 g eines amorphen Copolymerisats mit einer Glasübergangstemperatur von 144°C, dessen optische Eigenschaften in Beispiel 42.5 angegeben sind.
Zur Herstellung weiterer Copolymerisate verfährt man analog.

**Beispiel 41** Variation des Abstands der Absorptionsmaxima

Herstellung der Meßproben: 2 x 2 cm große Glasplättchen der Dicke 1.1 mm werden in einem Spincoater (Bauart Süss RC 5) placiert und mit 0,2 ml einer Lösung von 150 g der nachfolgend angegebenen Polymerisate in 1 l absolutem Tetrahydrofuran bei 2000 U/min in 10 sec beschichtet. Die Schicht ist 0,9 µm dick. transparent und amorph. Zwischen gekreuzten Polarisatoren erscheint die Fläche bei Tageslicht gleichmäßig dunkel. Anzeichen für polarisierende Bereiche werden nicht beobachtet.

Die Meßplättchen werden mit einem Ar-Ionen Laser mit einer Leistung von 250 mW/$cm^2$ bei einer Wellenlänge von 514 nm belichtet, wobei sich eine Doppelbrechung aufbaut. Die maximal erreichbare Doppelbrechung $\Delta n$ in der Polymerschicht wird in zwei Schritten bestimmt:

Zuerst wird der maximale induzierbare Gangunterschied $\Delta\lambda$, der zwischen gekreuzten Polarisatoren eine Aufhellung erzeugt, durch eine Messung mit einem Ehringhaus-Kompensator bestimmt. Die quantitative Bestimmung erfolgt durch die Kompensation der Aufhellung. Dies geschieht durch Drehung eines in den Strahlengang gebrachten Quarzkristalls, der die optische Weglänge und damit den Gangunterschied ändert. Man ermittelt nun den Gangunterschied, bei dem die Aufhellung vollständig kompensiert wird. Die Messung muß mit Licht einer Wellenlänge vorgenommen werden, die außerhalb des Absorptionsbereichs der Verbindungen liegt, um Resonanzeffekte zu vermeiden. In der Regel genügt ein He-Ne-Laser der Emissionswellenlänge 633 nm, bei langwelligen Absorptionen wird mit Licht eines Diodenlasers der Wellenlänge 820 nm gemessen. Die verwendete Auslesewellenlänge ist in den folgenden Tabellen unter der Spaltenüberschrift "λ" angegeben.

In einem zweiten Schritt wird die Schichtdicke des Polymers mit einem mechanisch wirkenden Schichtdikkenmeßgerät (Alphastep 200; Hersteller: Tencor Instruments) gemessen.

Die Doppelbrechungsänderung $\Delta n$ wird aus dem Quotienten des Gangunterschieds $\Delta\lambda$ und der Schichtdicke d bestimmt:

$$\Delta n = \frac{\Delta \lambda}{d}$$

Die Bestimmung der Absorptionsmaxima geschieht durch Auswerten der UV/Vis-Absorptionsspektren. Bei extremen Mischungen kann es vorkommen, daß nur noch ein Peak auswertbar ist. In solchen Fällen muß man den nicht ablesbaren Wert mit dem aus dem entsprechenden 1:1-Copolymerisat substituieren.

Zur Herstellung der Verbindungen und Messung der Daten verfährt man in den folgenden Beispielen analog.

Man erhält für den Fall $T^1=T^2$; $Q^1\neq Q^2$, $A\neq P$:

m Mol-%

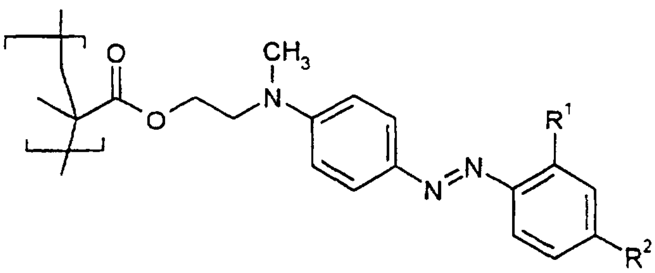

n Mol-%

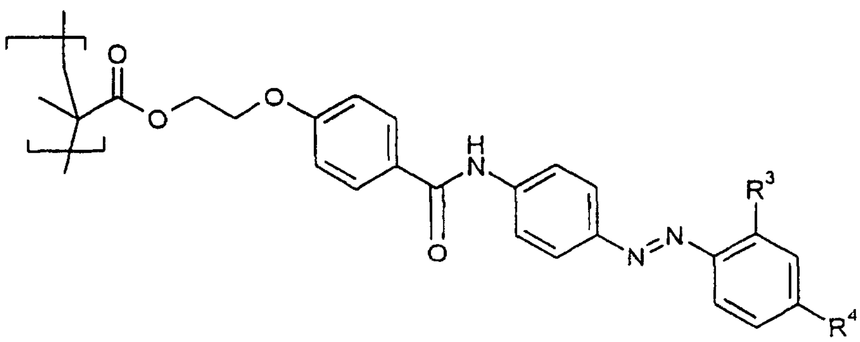

Formel 2

| Beispiel | $\nu_A$ | $\nu_P$ | $\Delta\nu_{P-A}$ | $\Delta n$ | n | m | mW/$cm^2$ | λ[nm] |
|---|---|---|---|---|---|---|---|---|
| $R^1$=H; $R^2$=CN; $R^3$=CN; $R^4$=CN | | | | | | | | |
| 41.1 | 22 900 | 25 300 | 2 600 | 0,110 | 70 | 30 | 250 | 820 |
| $R^1$=CN; $R^2$=CN; $R^3$=H; $R^4$=CN | | | | | | | | |

(fortgesetzt)

| Beispiel | $\nu_A$ | $\nu_P$ | $\Delta\nu_{P-A}$ | $\Delta n$ | n | m | mW/cm$^2$ | λ[nm] |
|---|---|---|---|---|---|---|---|---|
| 41.2 | 20 300 | 27 100 | 6 800 | 0,183 | 60 | 40 | 60 | 633 |
| 41.3 | 20 400 | 26 700 | 6 300 | 0,136 | 40 | 60 | 60 | 633 |
| $R^1$=H; $R^2$=$NO_2$;$R^3$=H; $R^4$=CN | | | | | | | | |
| 41.4 | 21 400 | 27 000 | 5 600 | 0,176 | 40 | 60 | 60 | 633 |
| $R^1$=$NO_2$; $R^2$=$NO_2$; $R^3$=CN; $R^4$=CN | | | | | | | | |
| 41.5 | 19 300 | 25 600 | 6 300 | 0,190 | 70 | 30 | 250 | 820 |
| $R^1$=$NO_2$; $R^2$=$NO_2$; $R^3$=H; $R^4$= $NO_2$ | | | | | | | | |
| 41.6 | 18 000 | 26 700 | 8 700 | 0,106 | 70 | 30 | 250 | 820 |

m Mol-%

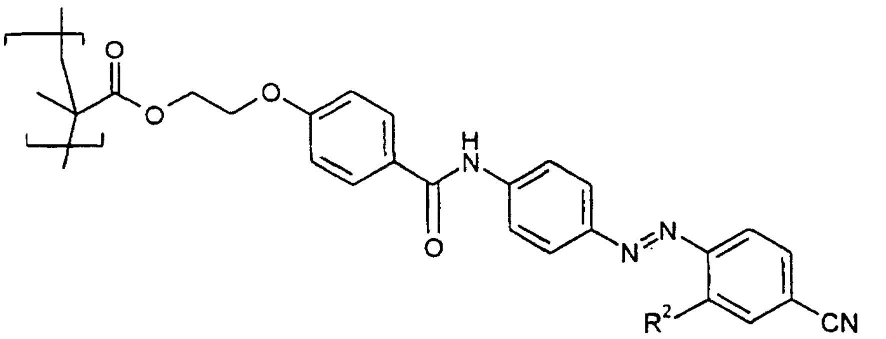

n Mol-%

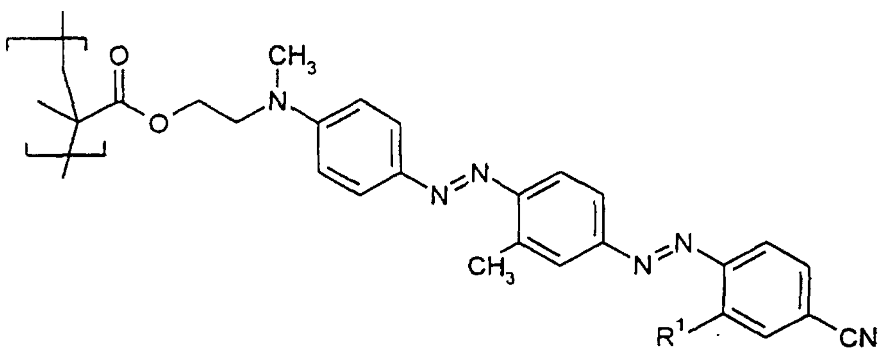

Formel 3

| Beispiel | $\nu_A$ | $\nu_P$ | $\Delta\nu_{P-A}$ | $\Delta n$ | m | n | mW/cm$^2$ | λ[nm] |
|---|---|---|---|---|---|---|---|---|
| $R^1$=$R^2$=H | | | | | | | | |
| 41.7 | 19 400 | 27 900 | 8 300 | 0,197 | 50 | 50 | 250 | 820 |
| $R^1$=H; $R^2$=CN | | | | | | | | |
| 41.8 | 20 000 | 25 400 | 5 400 | 0,287 | 70 | 30 | 250 | 820 |
| $R^1$=CN; $R^2$=CN | | | | | | | | |
| 41.9 | 19 000 | 25 900 | 6 900 | 0,295 | 60 | 40 | 250 | 820 |
| $R^1$= CN; $R^2$= H | | | | | | | | |
| 41.10 | 19 000 | 27 400 | 8 200 | 0,318 | 40 | 60 | 250 | 820 |

m Mol-%

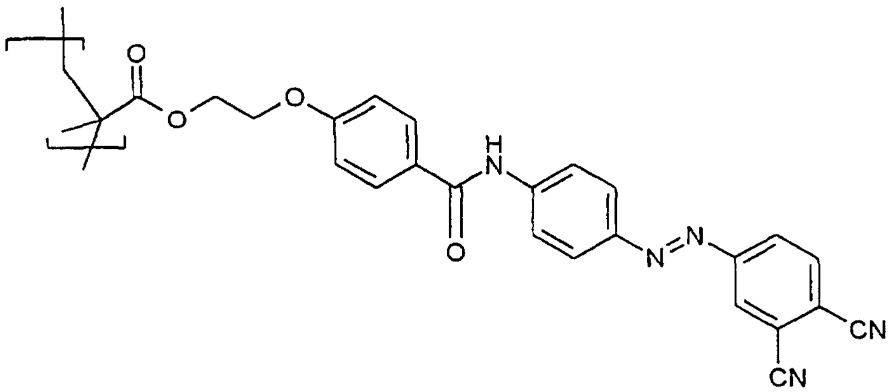

n Mol-%

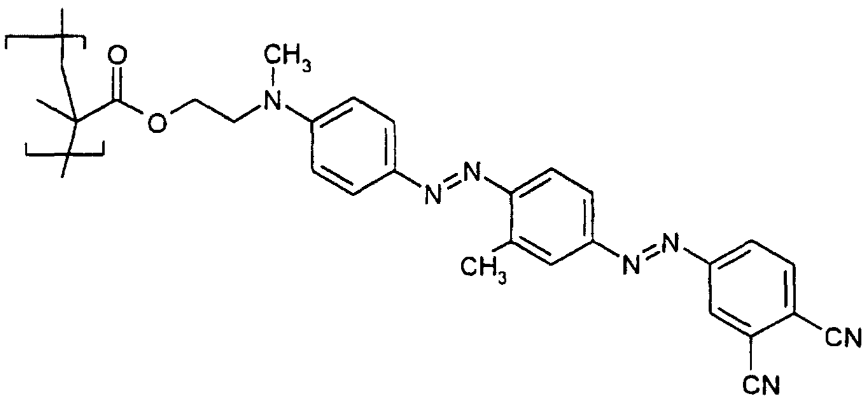

Formel 4

| Beispiel | $\nu_A$ | $\nu_P$ | $\Delta\nu_{P-A}$ | $\Delta n$ | m | n | mW/cm$^2$ | $\lambda$[nm] |
|---|---|---|---|---|---|---|---|---|
| 41.11 | 19 200 | 27 800 | 8 600 | 0,148 | 50 | 50 | 250 | 820 |

Formel 5

n Mol-%

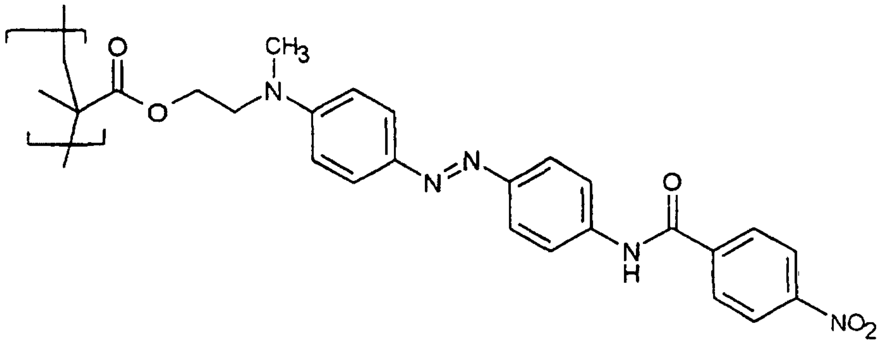

m Mol-%

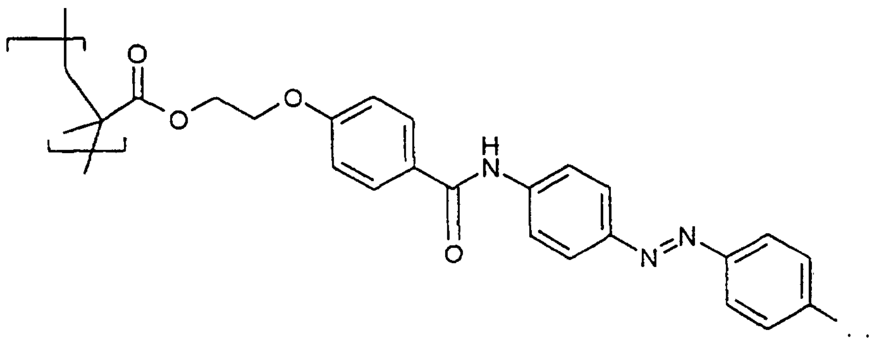

| Beispiel | $\nu_A$ | $\nu_P$ | $\Delta\nu_{P-A}$ | $\Delta n$ | m | n | mW/cm$^2$ | $\lambda$[nm] |
|---|---|---|---|---|---|---|---|---|
| 41.12 | 20 700 | 26 000 | 5 300 | 0,120 | 50 | 50 | 250 | 820 |

m Mol-%

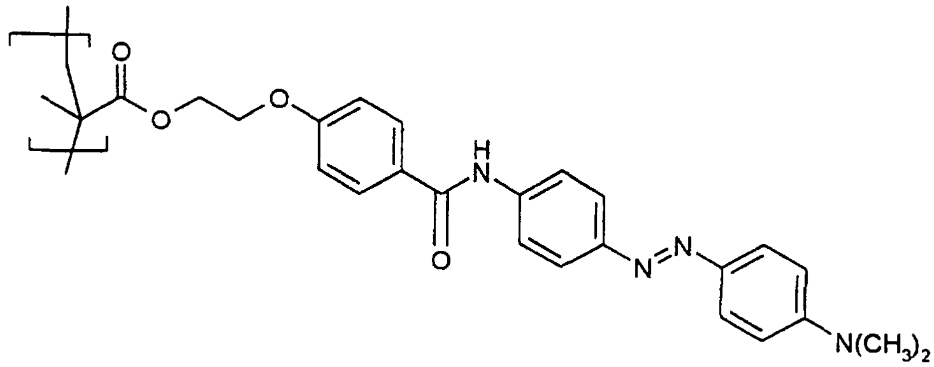

n Mol-%

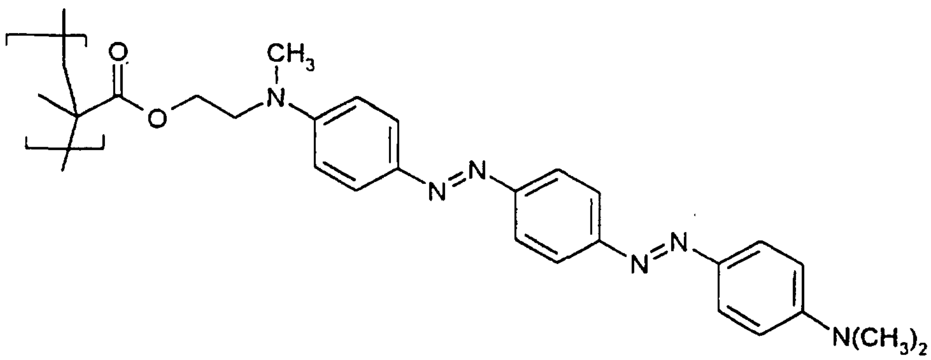

Formel 6

| Beispiel | $\nu_A$ | $\nu_P$ | $\Delta\nu_{P-A}$ | $\Delta n$ | m | n | mW/cm$^2$ | $\lambda$[nm] |
|---|---|---|---|---|---|---|---|---|
| 41.13 | 18 900 | 23 400 | 4 500 | 0,250 | 50 | 50 | 250 | 820 |

**Beispiel 42** $T^1=T^2$;Q1 $\neq$ $Q^2$, A = P

n Mol-%

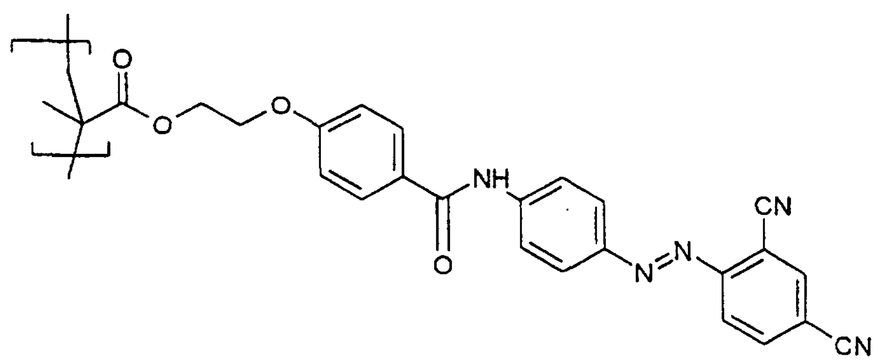

m Mol-%

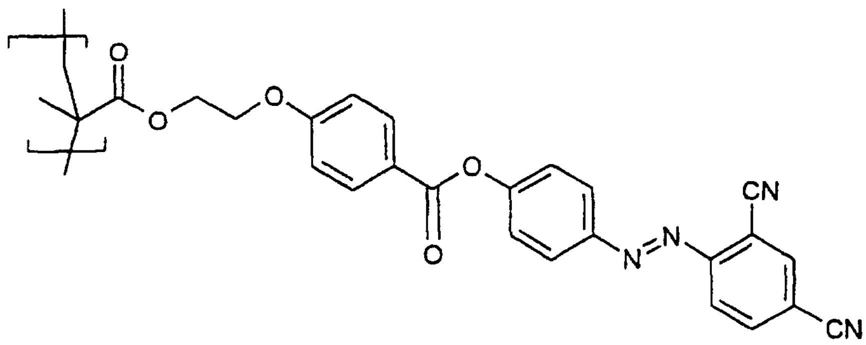

Formel 7

Analog Beispiel 1 wird ein Copolymerisat der Formel 7 hergestellt und entsprechend Beispiel 2 eine Probe gefertigt und gemessen. Man erhält eine Doppelbrechungsänderung Δn, eingeschrieben bei 488 nm wie folgt:

| Beispiel | $\nu_A$ | $\nu_p$ | $\Delta\nu_{P-A}$ | Δn | m | n | mW/cm² | λ[nm] |
|---|---|---|---|---|---|---|---|---|
| 42.1 | 25 000 | 28 000 | 3 000 | 0,232 | 50 | 50 | 250 | 633 |

n Mol-%

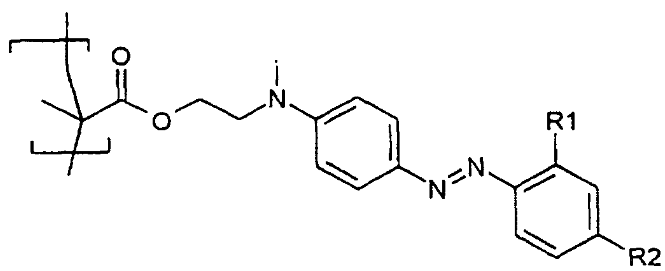

m Mol-%

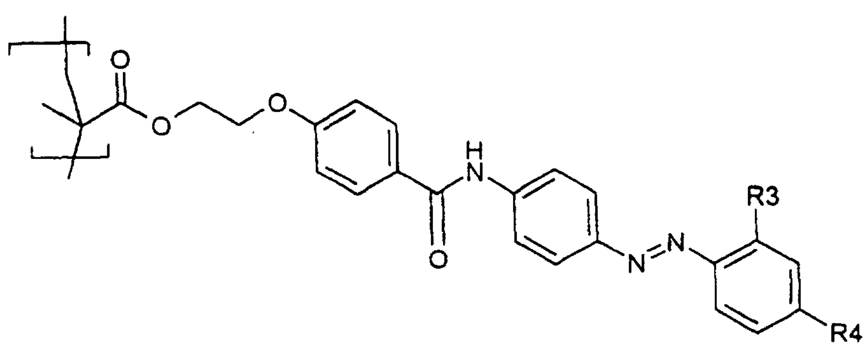

Formel 8

| Beispiel | $\nu_A$ | $\nu_P$ | $\Delta\nu_{P-A}$ | Δn | m | n | mW/cm² | λ[nm] |
|---|---|---|---|---|---|---|---|---|
| $R^1 = R^2 = R^3 = R^4 = CN$ | | | | | | | | |
| 42.2 | 20 400 | 25 800 | 5 400 | 0,175 | 90 | 10 | 120 | 633 |
| 42.3 | 20 400 | 25 400 | 5 000 | 0,231 | 80 | 20 | 60 | 633 |
| 42.4 | 20 400 | 25 300 | 4 900 | 0,414 | 70 | 30 | 60 | 633 |
| 42.5 | 20 400 | 25 000 | 4 600 | 0,158 | 60 | 40 | 120 | 633 |

(fortgesetzt)

| Beispiel | $\nu_A$ | $\nu_P$ | $\Delta\nu_{P-A}$ | $\Delta n$ | m | n | $mW/cm^2$ | $\lambda$[nm] |
|---|---|---|---|---|---|---|---|---|
| $R^1 = R^3 = H; R^2 = R^4 = NO_2$ | | | | | | | | |
| 42.6 | 19.200 | 26.700 | 7.500 | 0,171 | 70 | 30 | 250 | 820 |
| 42.7 | 19.800 | 25.600 | 5.800 | 0,145 | 50 | 50 | 250 | 820 |
| 42.8 | 21.300 | 25.000 | 2.700 | 0,116 | 30 | 30 | 250 | 820 |

**Beispiel 43** $T^1 \neq T^2$; $Q^1=Q^2$, A=P

Analog Beispiel 1 wird ein Copolymerisat der Formel

n Mol-%

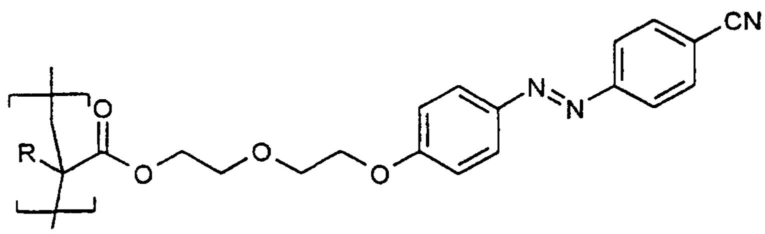

m Mol-%

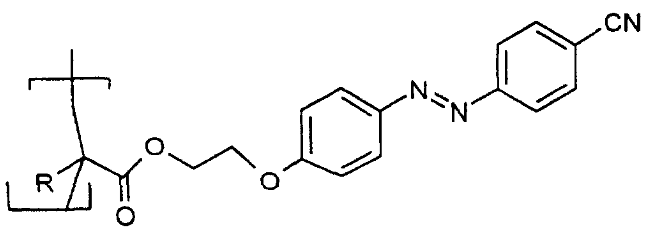

Formel 9

hergestellt.

| Beispiel | $\nu_A$ | $\nu_P$ | $\Delta\nu_{P-A}$ | $\Delta n$ | m | n | $mW/cm^2$ | $\lambda$[nm] |
|---|---|---|---|---|---|---|---|---|
| $R=CH_3$ | | | | | | | | |
| 43.1 | 27 000 | 27 400 | 400 | 0,103 | 60 | 40 | 200 | 633 |
| R=H | | | | | | | | |
| 43.2 | 27 600 | 28 300 | 500 | 0,104 | 60 | 40 | 200 | 633 |

**Beispiel 44** $T^1=T^2$; $Q^1=Q^2$, A≠P

m Mol-%

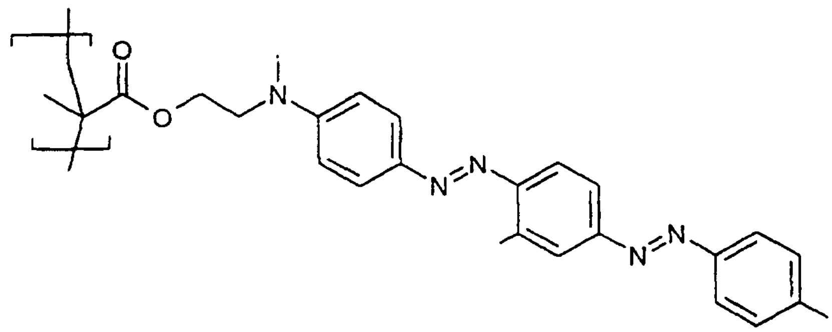

n Mol-%

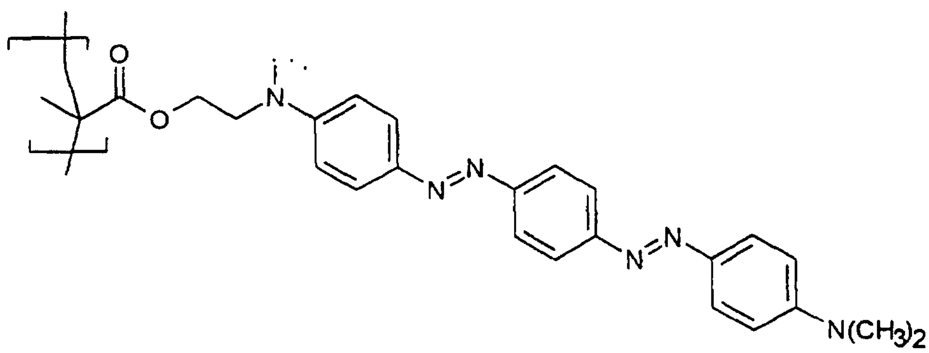

| Beispiel | $\nu_A$ | $\nu_P$ | $\Delta\nu_{P-A}$ | Δn | m | n | mW/cm$^2$ | λ[nm] |
|---|---|---|---|---|---|---|---|---|
| 44.1 | 21 600 | 23 400 | 1 800 | 0,211 | 50 | 50 | 60 | 633 |

**Beispiel 45** Wärmefestigkeit

Glasplättchen der Größe 2 x 2 cm werden wie in Beispiel 1 beschrieben mit einem Polymer gemäß Beispiel 3.3 beschichtet und 11 Felder (flatfields) so eingeschrieben, daß eine Reihe ansteigender Transmission zwischen ca. 0 und 82 % mit ungefähr gleichem Abstand entsteht. Die Transmission wird unmittelbar nach dem Einschreiben bestimmt. Sie definiert den Ausgangszustand. Man läßt diese Probe 2 Monate bei Raumtemperatur ohne weiteren Schutz abgedunkelt liegen. Danach lagert man je ein weiteres dieser Plättchen 24 h bei 60°C, 80°C und 120°C in einem Trockenschrank und bestimmt die Transmission erneut. Man erhält so 4 Wertereihen, die mit dem Ausgangszustand verglichen werden. In der folgenden Tabelle 1 sind die Werte für die Transmission angegeben:

Tabelle 1

| Ausgangszustand | 2 Mt./ 20°C | 24 h/ 60°C | 24 h/ 80°C | 24 h/ 120°C |
|---|---|---|---|---|
| 82 | 75,4 | 68,9 | 83,6 | 72,2 |
| 73,8 | 67,2 | 65,6 | 75,4 | 68,9 |
| 65,6 | 60,7 | 59,0 | 64,0 | 54,1 |
| 50,8 | 45,9 | 52,5 | 55,8 | 49,2 |
| 54,1 | 45,9 | 52,5 | 55,8 | 44,3 |

Tabelle 1 (fortgesetzt)

| Ausgangszustand | 2 Mt./ 20°C | 24 h/ 60°C | 24 h/ 80°C | 24 h/ 120°C |
|---|---|---|---|---|
| 19,7 | 24,6 | 29,5 | 37,7 | 19,7 |
| 32,8 | 21,3 | 24,6 | 29,5 | 16,4 |
| 19,7 | 14,8 | 14,8 | 26,2 | 16,4 |
| 9,8 | 9,8 | 13,1 | 16,4 | 11,5 |
| 6,6 | 6,6 | 11,5 | 11,5 | 9,8 |
| 0 | 0 | 6,6 | 8,2 | 4,9 |

In der ersten Spalte sind die Werte für die frisch hergestellte Probe bei Raumtemperatur gemessen angegeben, in Spalte 2 ist die gleiche Messung nach 2 Monaten Lagerzeit wiederholt worden. Die übrigen Spalten entsprechen den Meßreihen nach Lagerung bei der in der ersten Zeile angegebenen Temperatur. Trägt man die Werte aus den Spalten 2 bis 5 gegen die in der Spalte 1 auf, so erhält man eine Gerade mit der Steigung 1. Die Graustufen verändern sich also nicht bei der Einwirkung erhöhter Temperatur.

## Patentansprüche

1. Verwendung von fotoadressierbaren Polymere, die an einer als Rückgrat wirkenden Hauptkette Seitenketten unterschiedlicher Art tragen, die beide elektromagnetische Strahlung (mindestens für die eine Art: vorzugsweise die Wellenlänge des sichtbaren Lichts) absorbieren können mit der Maßgabe, dass die Absorptionsmaxima der unterschiedlichen Seitenketten mindestens 200 und maximal 10 000 $cm^{-1}$ voneinander entfernt sind, zum Speichern von Informationen in Flächengebilde, wobei zunächst eine optische Anisotropie $\Delta n$ von 0,001 bis 0,95 erzeugt wird und anschließend durch Bestrahlung mit Licht einer Energiedichte von $10^3$ bis $10^7$ $mJ/m^2$ während einer Zeitdauer von $10^{-3}$ bis $10^{-15}$ sec die optische Anisotropie gezielt partiell variiert wird und so die optische Information gespeichert wird.

2. Flächengebilde gemäß Anspruch 1.

3. Verwendung der Polymere nach Anspruch 1 als holographisches Aufzeichnungsmaterial.

4. Verfahren zum Speichern von Mustern in den gemäß Anspruch 1 zu verwendenden Flächengebilden durch Bestrahlung mit Licht einer Energiedichte von $10^3$ bis $10^7$ $mJ/m^2$ während einer Zeitdauer von $10^{-3}$ bis $10^{-15}$ sec.

5. Verwendung der Polymere nach einem oder mehrerer der vorangegangen Ansprüche, wobei die Polymere die Seitengruppen der Formeln

$$-S^1-T^1-Q^1-A \qquad (I)$$

und

$$-S^2-T^2-Q^2-P \qquad (II),$$

besitzen und

$S^1$, $S^2$ unabhängig voneinander Sauerstoff, Schwefel oder $NR^1$,

$R^1$ Wasserstoff oder $C_1$-$C_4$-Alkyl,

$T^1$, $T^2$ unabhängig voneinander den Rest $(CH_2)_n$, der gegebenenfalls durch -O-, $-NR^1-$ oder $-OsiR^1_2O-$ unterbrochen und/oder gegebenenfalls durch Methyl oder Ethyl substituiert sein kann,

n die Zahlen 2, 3 oder 4,

$Q^1$, $Q^2$ unabhängig voneinander einen zweibindigen Rest,

A, P unabhängig voneinander eine Einheit, die elektromagnetische Strahlung aufnehmen kann,

darstellen.

**6.** Polymere wie in den Ansprüchen 1 bis 5 definiert, wobei A und P den Formeln

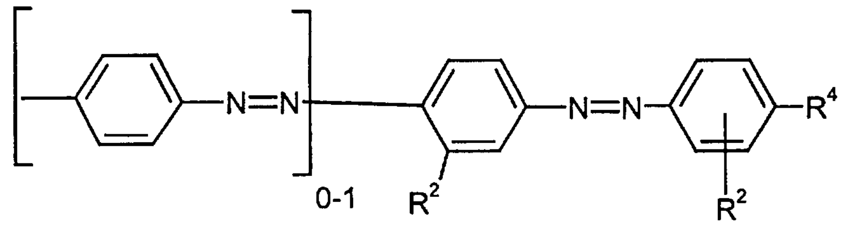

(X)

und

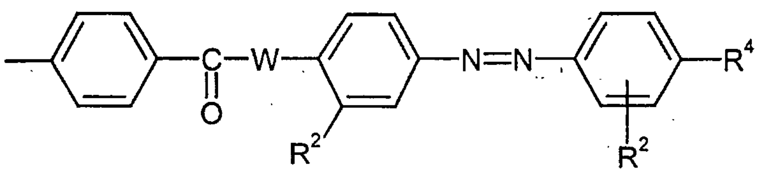

(XI)

entsprechen, worin

$R^2$ Wasserstoff oder Cyano,

$R^{2'}$ Wasserstoff oder Methyl,

W Sauerstoff oder $NR^1$ und

$R^4$ Nitro, Cyano, Benzamido, p-Chlor-, p-Cyano-, p-Nitrobenzamido oder Dimethylamino bedeuten.

**7.** Polymere nach Ansprüchen 6, worin die Gruppen $-S^1-T^1-Q^1-$ bzw. $-S^2-T^2-Q^2-$ den Formel $-OCH_2CH_2O-$, $-OCH_2CH_2OCH_2CH_2O-$ und $-OCH_2CH_2-NR^1-$ entsprechen.

**8.** Polymere nach Ansprüchen 5-7, worin die Hauptkette ein Poly(meth)acryloyl ist.

**9.** Polymere nach Ansprüchen 5-8, in die mit polarisiertem Licht Doppelbrechungsänderungen $\Delta n$ von über 0,15 eingeschrieben werden können.

**10.** Verfahren zur Herstellung von Polymeren nach Ansprüchen 5-9, wonach man Monomere der Formeln

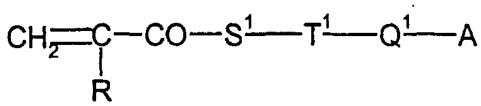

und

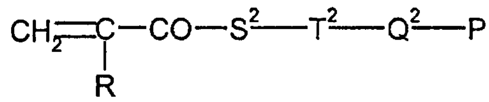

sowie gegebenenfalls weitere Monomere miteinander copolymerisiert.

**11.** Filme aus Polymeren nach Ansprüchen 5 bis 9.

**12.** Mit Filmen nach Anspruch 11 beschichtete Träger.

**13.** Verwendung von Polymeren nach Ansprüchen 5 bis 12 zur Herstellung optischer Bauelemente.

**Revendications**

**1.** Utilisation de polymères photostimulables, qui portent sur une chaine principale agissant comme tronc, des chaines latérales de différents types, qui peuvent absorber un rayonnement électromagnétique (au moins pour un type ; de préférence aux longueurs d'onde de la lumière visible), avec la condition que les maxima d'absorption des différentes chaines latérales s'écartent l'un de l'autre d'au moins 200 et au maximum 10 000 $cm^{-1}$, pour mémoriser ou stocker des informations dans des structures surfaciques, où au moins une anisotropie optique $\Delta n$ de 0,001 à 0,95 est produite et ensuite, par irradiation avec de la lumière ayant une densité d'énergie de $10^3$ à $10^7$ $mJ/m^2$ pendant une période allant de $10^{-3}$ à $10^{-15}$ seconde, l'anisotropie optique est variée partiellement de manière ciblée et ainsi, l'information optique est sauvegardée.

**2.** Structure surfacique suivant la revendication 1.

**3.** Utilisation des polymères suivant la revendication 1, en tant que matériau d'enregistrement holographique.

**4.** Procédé de mémorisation ou de stockage de modèles dans les structures surfaciques à utiliser suivant la revendication 1, par irradiation avec de la lumière d'une énergie lumineuse allant de $10^3$ à $10^7$ $mJ/m^2$ pendant une période allant de $10^{-3}$ à $10^{-15}$ seconde.

**5.** Utilisation des polymères suivant l'une ou plusieurs des revendications précédentes, où les polymères possèdent les groupes latéraux de formules :

$$-S^1-T^1-Q^1-A \qquad (I),$$

et

$$-S^2-T^2-Q^2-P \qquad (II)$$

où

$S^1$, $S^2$ représentent indépendamment l'un de l'autre, les atomes d'oxygène, de soufre ou le radical $NR^1$ ;
$R^1$ représente l'atome d'hydrogène ou un radical alcoyle en $C_1$-$C_4$ ;
$T^1$, $T^2$ représentent indépendamment l'un de l'autre, un reste $(CH_2)_n$, qui peut être le cas échéant, interrompu par -O-, $-NR^1-$ ou $-OSiR^1_2O-$ et/ou substitué par le radical méthyle ou éthyle ;
n représente le nombre 2, 3 ou 4 ;
$Q^1$, $Q^2$ représentent indépendamment l'un de l'autre, un reste bivalent ;
A, P représentent indépendamment l'un de l'autre, une unité qui peut absorber un rayonnement électromagnétique.

**6.** Polymère tel que défini dans l'une quelconque des revendications 1 à 5, où A et P correspondent aux formules :

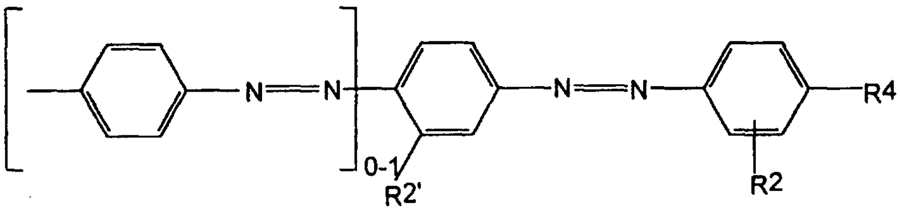

(X)

et

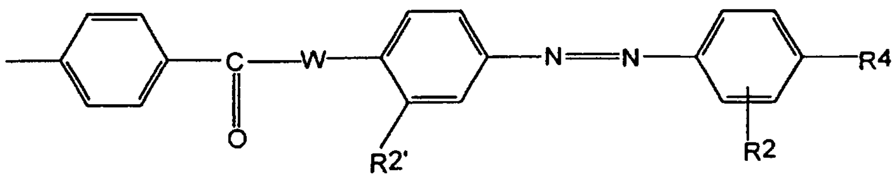

(XI)

où

$R^2$ représente l'atome d'hydrogène ou le radical cyano,
$R^{2'}$ représente l'atome d'hydrogène ou le radical méthyle,
W représente l'atome d'oxygène ou le radical $NR^1$, et
$R^4$ représente le radical nitro, cyano, benzamido, p-chloro-, p-cyano-, p-nitrobenzamido ou diméthylamino.

**7.** Polymère suivant la revendication 6, où les groupes $-S^1-T^1-Q^1-$ et respectivement $-S^2-T^2-Q^2-$ correspondent aux formules $-OCH_2CH_2O-$, $-OCH_2CH_2OCH_2CH_2O-$ et $-OCH_2CH_2-NR^1-$.

**8.** Polymère suivant les revendications 5 à 7, où la chaine principale est un poly(méth)acryloyle.

**9.** Polymère suivant les revendications 5 à 8, dans lequel on peut inscrire des modifications de biréfringence $\Delta n$ de plus de 0,15 avec la lumière polarisée.

**10.** Procédé de préparation de polymères suivant les revendications 5 à 9, dans lequel on copolymérise des monomères de formules :

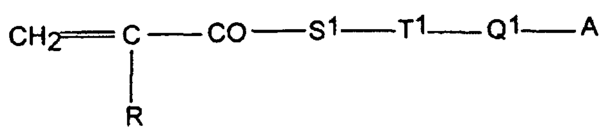

et

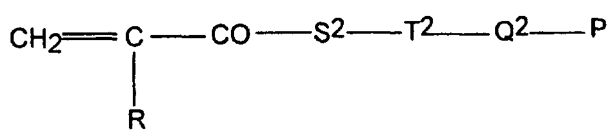

ainsi que le cas échéant, d'autres monomères.

**11.** Films en les polymères suivant les revendications 5 à 9.

**12.** Supports enduits des films suivant la revendication 11.

**13.** Utilisation de polymères suivant les revendications 5 à 12, pour préparer des éléments optiques.

**Claims**

**1.** Use of photo-addressable polymers that carry side chains of various types on a main chain acting as a skeleton, the main chain as well as the side chains being able to absorb electromagnetic radiation (at least one type of radiation, preferably the wavelength of visible light), with the proviso that the absorption maxima of the different side chains are separated from one another by at least 200 $cm^{-1}$ and at most 10,000 $cm^{-1}$, for the storage of information in sheet material, wherein first of all an optical anisotropy $\Delta n$ of 0.001 to 0.95 is generated and the optical anisotropy is then purposefully partially varied by irradiation with light of an energy density of $10^3$ to $10^7$ $mJ/m^2$ for a duration of $10^{-3}$ to $10^{-15}$ sec. and the optical information is thus stored.

**2.** Sheet material according to claim 1.

**3.** Use of the polymers according to claim 1 as holographic recording material.

**4.** Process for the storage of patterns in the sheet materials to be used according to claim 1, by irradiation with light of an energy density of $10^3$ to $10^7$ $mJ/m^2$ for a duration of $10^{-3}$ to $10^{-15}$ sec.

**5.** Use of the Polymers according to one or more of the preceding claims, wherein the polymers have the side groups of the formulae

$$-S^1-T^1-Q^1-A \quad (I)$$

and

$$-S^2-T^2-Q^2-P \quad (II),$$

and

$S^1$, $S^2$ independently of one another denote oxygen, sulfur or $NR^1$,

$R^1$ denotes hydrogen or $C_1$-$C_4$ alkyl,

$T^1$, $T^2$ independently of one another denote the radical $(CH_2)_n$, which may optionally be interrupted by -O-, $-NR^1-$ or $-OsiR^1{}_2O-$ and/or may optionally be substituted by methyl or ethyl,

n denotes the numbers 2, 3 or 4,

$Q^1$, $Q^2$ independently of one another denote a divalent radical,

A, P independently of one another denote a unit that can absorb the electromagnetic radiation.

**6.** Polymers as defined in claims 1 to 5, wherein A and P correspond to the formulae

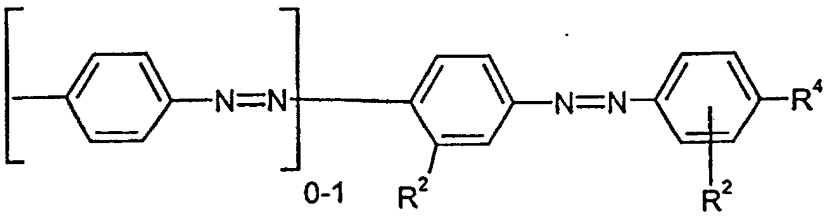

(X)

and

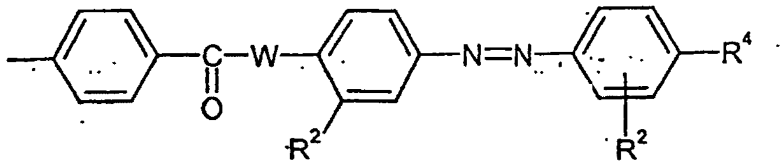

(XI)

wherein

$R^2$ denotes hydrogen or cyano

$R^{2'}$ denotes hydrogen or methyl,

W denotes oxygen or $NR^1$, and

$R^4$ denotes nitro, cyano, benzamido, p-chlorobenzamido, p-cyanobenzamido, p-nitrobenzamido or dimethylamino.

**7.** Polymers according to claim 6, wherein the groups $-S^1-T^1-Q^1-$ and/or $-S^2-T^2-Q^2-$ correspond to the formulae $-OCH_2CH_2O-$, $-OCH_2CH_2OCH_2CH_2O-$ and $-OCH_2CH_2-NR^1-$.

**8.** Polymers according to claims 5 to 7, wherein the main chain is a poly(meth)acryloyl chain.

**9.** Polymers according to claims 5 to 8, in which double refraction changes Δn of more than 0.15 can be inscribed with polarised light.

**10.** Process for the production of polymers according to claims 5 to 9, wherein monomers of the formulae

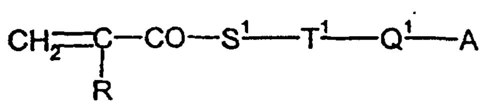

and

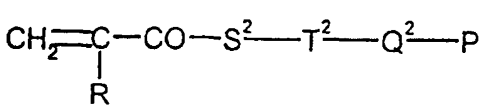

as well as optionally further monomers are copolymerised with one another.

**11.** Films formed from polymers according to claims 5 to 9.

12. Carrier coated with films according to claim 11.

13. Use of polymers according to claims 5 to 12 for the production of optical structural elements.

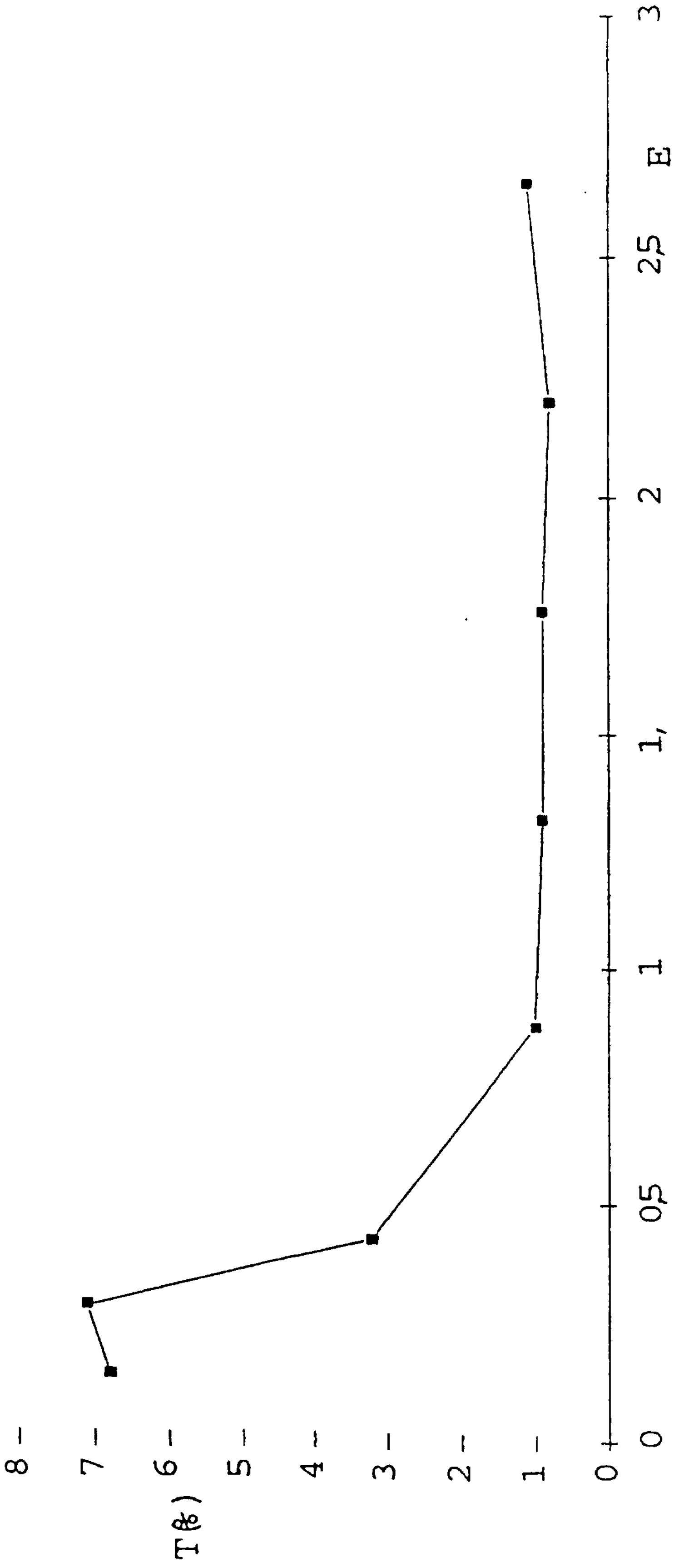


Fig. 1

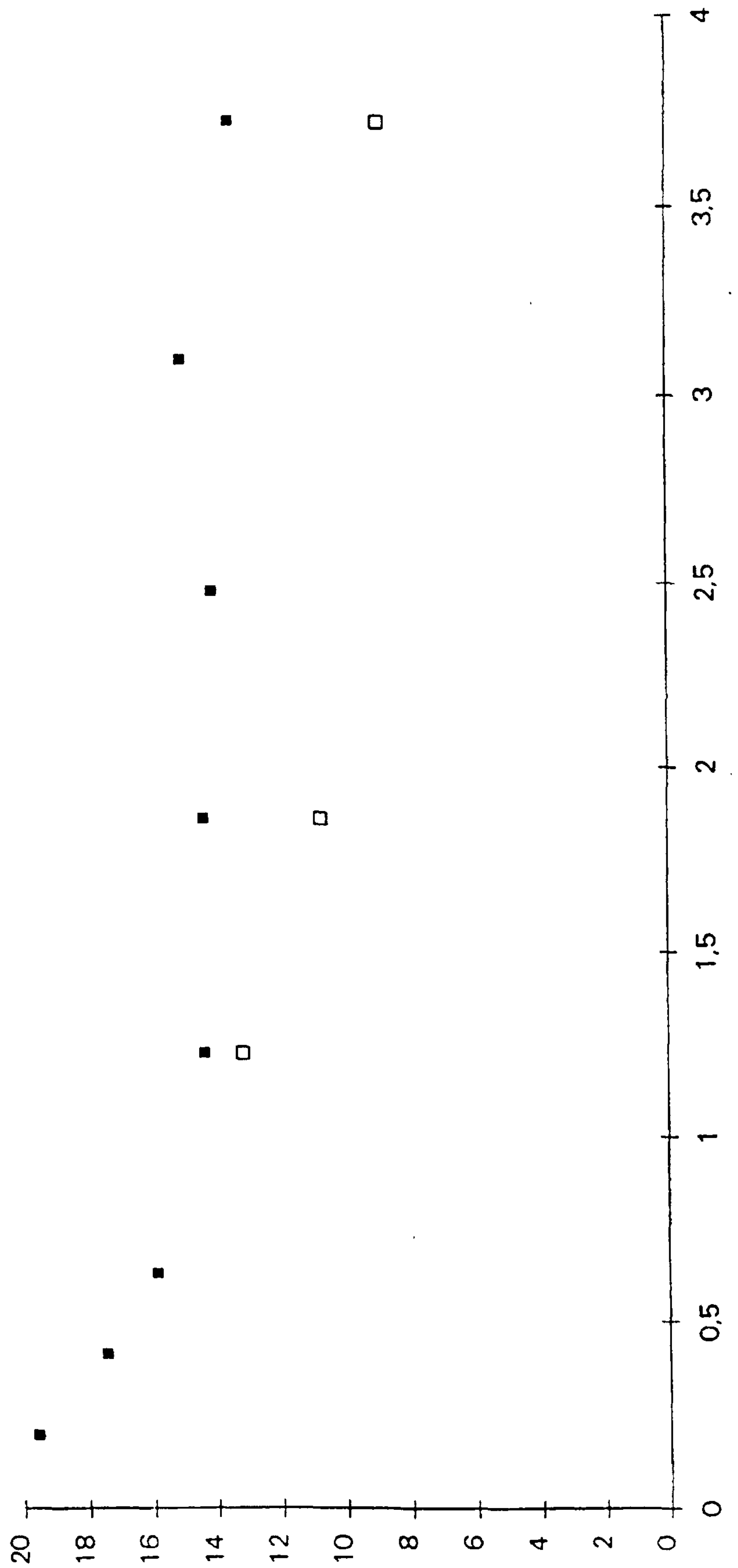


Fig. 2

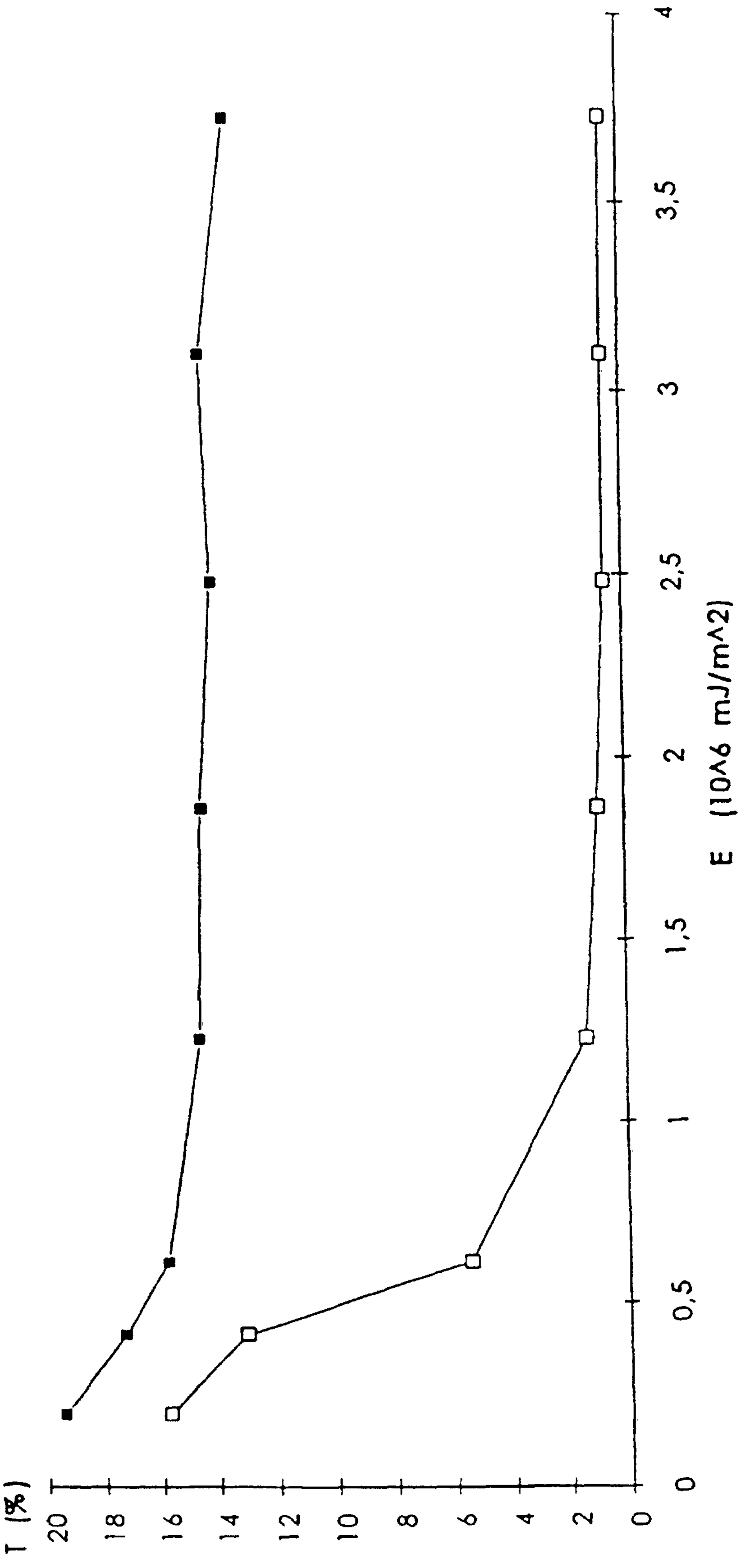


Fig. 3

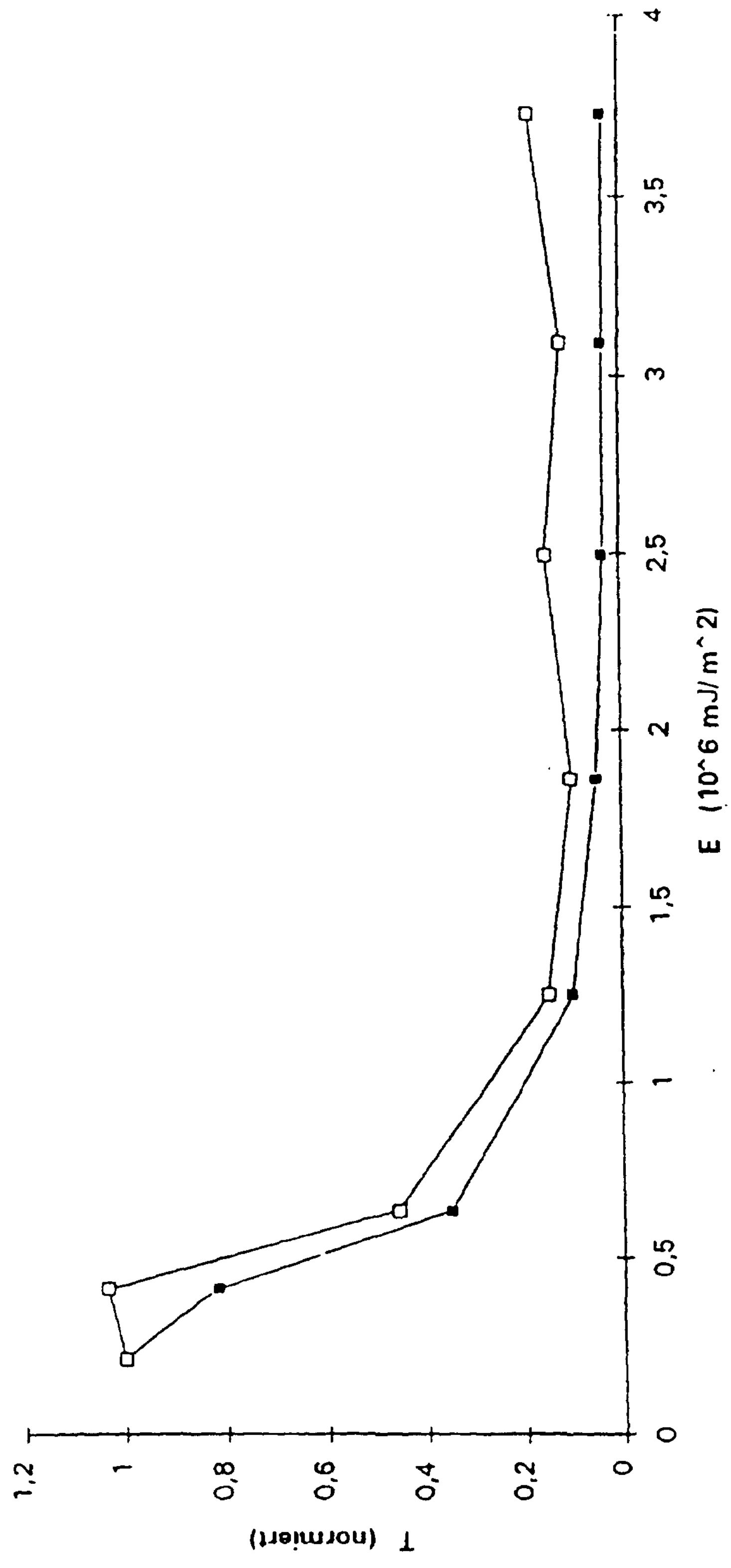


Fig. 4

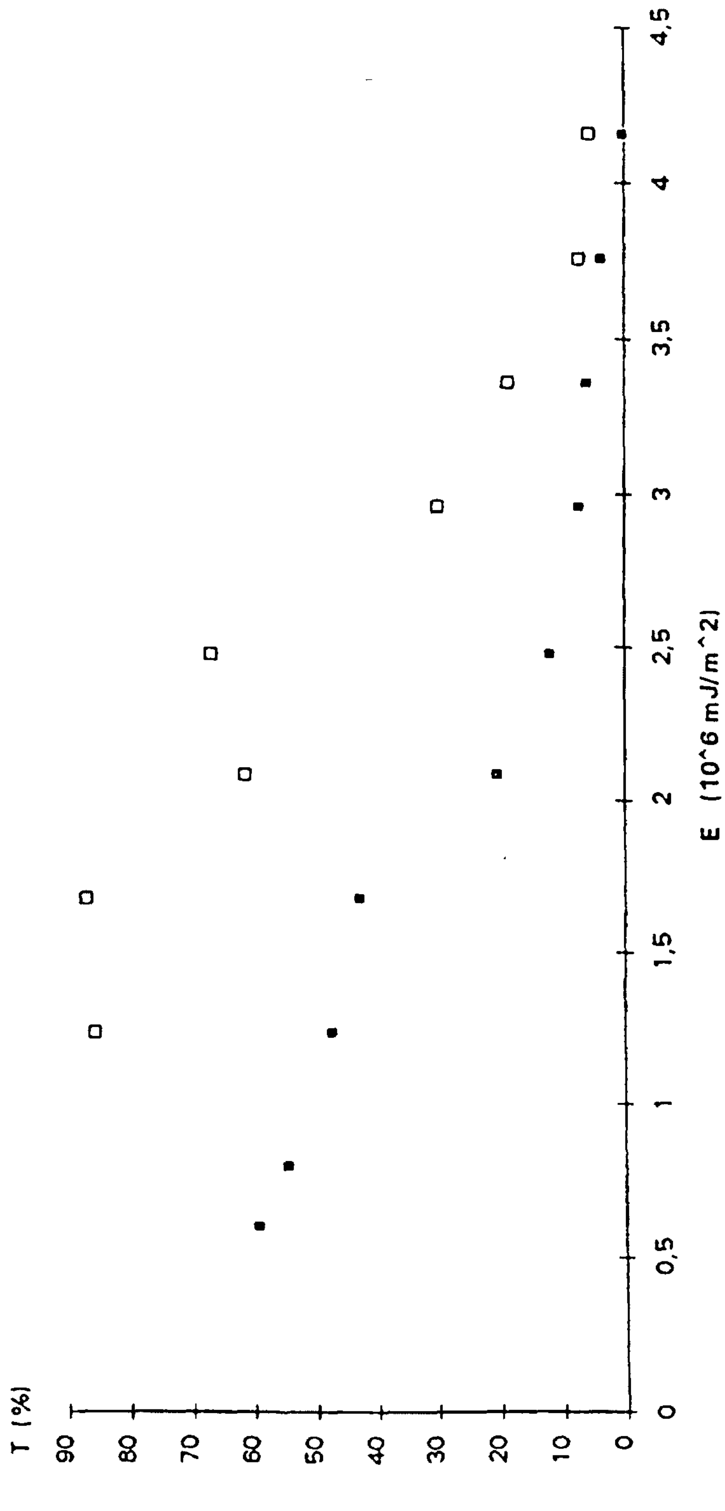


Fig. 5